Europäisches Patentamt

European Patent Office

Office européen des brevets

(19)

(11)     EP 0 823 667 A2

(12)     EUROPEAN PATENT APPLICATION

(43) Date of publication:
     11.02.1998  Bulletin 1998/07

(51) Int. Cl.⁶: $G03F\ 9/00$

(21) Application number: 97113575.1

(22) Date of filing: 06.08.1997

(84) Designated Contracting States:
     AT BE CH DE DK ES FI FR GB GR IE IT LI LU MC
     NL PT SE

(30) Priority: 06.08.1996 JP 207100/96
               06.08.1996 JP 207101/96
               14.10.1996 JP 270631/96

(71) Applicant: NIKON CORPORATION
     Tokyo 100 (JP)

(72) Inventors:
     • Mizutani, Hideo
       3-chome, Chiyoda-ku, Tokyo (JP)
     • Kawaguchi, Toru
       3-chome, Chiyoda-ku, Tokyo (JP)

(74) Representative:
     Ritter und Edler von Fischern, Bernhard, Dipl.-
     Ing. et al
     Hoffmann Eitle,
     Patent- und Rechtsanwälte,
     Arabellastrasse 4
     81925 München (DE)

(54)     Alignment apparatus and exposure apparatus equipped with same

(57)     A heterodyne interference-type alignment sensor that permits the high-precision matching of detection light eams to suit the pitch of the diffraction grating marks to be detected without introducing undue complexity to the optical system. Light beams $L_0$ of a given wideband width are illuminated onto an acousto-optical modulator to obtain light beams $L_1$ (1), $L_2$ (-1) comprising ± 1st order beams, which are further directed to diffraction grating marks RM, WM via a relay optical system. The diffracted beams from diffraction grating marks RM, WM are detected by photoelectric detectors. The frequencies $f_1$, $f_2$, applied to the acousto-optical modulator are varied while maintaining a correspondence between the difference between frequencies $f_1$, $f_2$ and the pitch of diffraction grating marks RM, WM.

FIG. 1(A)

(Cont. next page)

**FIG. 1(B)**

**Description**

This application claims the benefit of Japanese Applications Number 08-207100 filed on August 6, 1996, 08-707101 filed on August 6, 1996, and 08-270631 filed on October 14, 1996, which are hereby incorporated by reference.

## BACKGROUND OF THE INVENTION

### Field of the Invention

The present invention relates to a heterodyne interference alignment apparatus as well as to an exposure apparatus equipped with this apparatus, used in the lithography process for the fabrication of devices such as semiconductors, image pick-up devices, liquid crystal displays, and thin-film magnetic head devices. The present invention further relates to a position detecting method and apparatus for detecting the position deviation of two alignment marks.

## DESCRIPTION OF THE RELATED ART

Conventionally, exposure equipment is used for the formation of micro-patterns such as semiconductor devices. Such equipment includes steppers and other projection exposure apparatus that transcribe reticle (or photomask) patterns onto a photosensitive substrate such as a wafer or a glass plate, through a projection optical system. Semiconductor devices, for example, are formed by stacking multi-layer circuit patterns on a wafer in a predetermined geometry. The transcription of circuit patterns to the second and subsequent layers an the wafer requires the precise alignment of the circuit patterns in shot regions that have previously been formed with a reticle pattern.

In order to perform precise alignment, an exposure apparatus is equipped with an alignment apparatus, including an alignment sensor, which performs high-precision detection of the positions of the reticle and the wafer, and an alignment mechanism, for example, a stage mechanism, which positions the reticle and the wafer based upon the results of the detection.

Heterodyne interference equipment of different types described below have been proposed as an alignment apparatus for the high-precision detection of the positions of reticles and wafers.

In a first type of heterodyne interference equipment an alignment sensor uses, for example, a diffraction grating to divide a white light source (or laser beams with multiple wavelengths) into two light beams. The alignment senior obtains a zeroth order beam and an isotropic Bragg diffraction 1st order diffraction beam, respectively, by symmetrically passing the two-way split light beams through a first acousto-optic modulator ("AOM") . After the first AOM, a second AOM is provided through a relay optical system, and a 1st order diffraction beam is extracted by isotropic Bragg diffraction in the second AOM from the two 1st order diffracted beams from the first AOM. In this case, ultrasonic waves with a specified frequency difference, $\Delta f$ are applied to the first and second AOMs so that the two 1st order diffracted beams emitted from the second AOM will be light beams (heterodyne beams) with a frequency difference of $2\Delta f$. Generally, AOMs have high drive frequencies. In their original form, AOMs produce a frequency difference that is too high in the heterodyne beams that they generate, thus requiring a complex signal processing system. By using an array of two AOMs, it is possible to beat-down the heterodyne beam frequency difference.

The two light beams having the reduced frequency difference are directed onto the diffraction grating marks and serve as alignment marks. The diffracted beams that are generated by the diffraction grating marks in the same direction are made to interfere with each other. The resulting interference light patterns are photoelectrically converted by means of photoelectric detectors to obtain two optical beat signals. The phase difference between these two optical beat signals corresponds to the magnitude of the positional deviation between the two diffraction rating marks. This permits enabling high-precision alignment between the reticle and the wafer to be achieved by using the optical beat signals. This structure prevents any mixing of light beams of different frequencies at the AOM stage, and ensures the production of optical beat signals with a high S/N ratio.

In a second type of heterodyne interference equipment, ultrasonic waves of opposite directions having different frequencies, are applied within one AOM. Light beams having a specified band-width are input into the AOM. The ±1st order diffracted beams having a predetermined frequency difference and generated by isotropic Raman-Nath diffraction in that AOM are directed onto the diffraction grating marks on the reticle and the wafer through a predetermined relay optical system. This structure both simplifies and reduces the size of the optical system that generates heterodyne beams.

In the prior art, using the first type of alignment sensor, the first-stage diffraction grating for dividing light beams becomes conjugate with the diffraction grating mark (the alignment mark) to be detected. Thus, the ratio of the pitch for the diffraction grating and the pitch for the diffraction grating mark assumes a predetermined value. Consequently, in situations where the pitch for the diffraction grating mark to be detected changes due to the particular process employed, a magnification-varying mechanism must be provided between the diffraction grating and the diffraction grating mark. If there is any magnification error in the relay optical system located between the diffraction grating and the diffraction grating mark, the magnification factor for the relay optical system must be adjusted.

Using the second type of alignment sensor, the site that generates progressive waves that advance through the medium inside the AOM becomes conjugate with the diffraction grating mark. Consequently, after the pitch for the progressive waves is relayed, this pitch must be matched with the pitch for the diffraction grating mark. In conventional AOMs, ultrasonic waves of a constant frequency are applied and the pitch for the progressive waves that are generated is constant. Therefore, as in the case of the first type of alignment sensor, the detection of the positions of diffraction grating marks of different pitches requires the provision of a magnification-varying mechanism in the relay optical system, and the magnification factor for the relay optical system must be adjusted.

However, the degree of precision required to match the pitch for either the diffraction grating for light beamsplitting or for the progressive waves inside an AOM with the pitch for the diffraction grating mark to be detected is ordinarily less than 0.1%. Any magnification-varying mechanism for achieving such high-precision matching is necessarily complex, and the adjustment of such a mechanism is a time-consuming process. These are disadvantages. Similarly, when it is necessary to adjust the magnification factor for a relay optical system, the adjustment process is time-consuming.

Furthermore, in resent years there have been cases where it has been necessary to sequentially detect diffraction grating marks of multiple types having pitches ouch as $4\mu$ m, $6\mu$ m, and $8\mu$ m according to the types of layers that are constructed on a wafer. However, in conventional alignment sensors, the difficulty of making adjustments to the magnification-varying mechanism and the relay optical system hampers the process of quickly switching the detection mechanism according to the pitch of the diffraction grating mark to be detected.

In addition, the first type of alignment apparatus uses two AOMs for beating down the frequency difference between the two light beams. To serve the purpose, another diffraction grating is rehired for producing two beams to be introduced to these AOMs. In addition, to induce the isotropic Bragg diffraction in the AOM properly, the two AOMs must be illuminated at an angle such that the diffracted light beams and the zeroth order beams can be separately directed. At the same time, the method requires a spatial filter, which has made the configuration complex.

Another disadvantage of the second type of alignment apparatus is that the diffraction efficiency decreases to approximately 60% and unwanted high frequencies are combined to affect detection accuracy. In addition, both types of alignment sensors have an AOM with acousto-optical modulator medium, which needs to have an large ultrasonic wave operating region to enlarge the alignment diffraction grating marks on a reticle and a wafer. A large ultrasonic wave operating region requires an ultrasonic wave power of over 1W, which is larger than normal. This rises the temperature in the apparatus, thus causing unfavorable results which affect alignment accuracy.

In the past, it has been suitable to use a TTR (through the reticle) type of alignment sensor to detect positional deviations between an alignment mark on a mask and an alignment mark on a photosensitive substrate via a projection optical system located above the mask in the projection exposure apparatus used in lithographic processes. In the TTR method, a known type of alignment sensor uses the two-beam interference method to illuminate a diffraction grating type of alignment mark with coherent light beams from two directions to detect the position of the alignment mark based on the phase of the interference light formed by the plurality of diffracted light beams generated from the alignment mark in the same direction. The two-beam interference method is also known as the LIA (Laser Interferometric Alignment) method. The two-beam interference method can be divided into two methods, the heterodyne interference method described above as using two light beams with slightly different frequencies and the homodyne interference method which uses two light beams with the same frequency.

Alignment sensors normally use a light beam that does not react with the photoresist on the wafer (non-exposure light) as the alignment light. However, when non-exposure light is used as the alignment light in the TTR type of alignment sensor, the exposure optical system corrects chromatic aberration in the exposure light, so the conjugate relationship of the reticle and wafer based on the alignment light cannot be maintained because of chromatic aberration in the exposure optical system. Precise detection of positional deviation between the reticle mark and the water mark becomes difficult in the shared detection system.

Therefore, for example, Japanese Laid-open Patent Hei 4-7814 (U.S. Patent No. 5,214,489) discloses a two-beam interference type alignment sensor which makes the reticle mark grating pitch ½ the wafer mark grating pitch in terms of projection magnification, and uses mutually independent detection systems to compare the individual optical beat signals obtained from the reticle mark and the wafer mark to detect position. This alignment sensor also takes into account that projection magnification based on alignment light that is non-exposure light differs from projection magnification based on exposure light.

This type of two-beam interference type alignment sensor can detect the position of an alignment mark with very high precision. Nevertheless, in a conventional two-beam interference type alignment sensor, in order to detect the positional deviation of a reticle mark and a wafer mark the reticle mark and the wafer mark are irradiated in a way that their alignment light is not superimposed. This requires detecting the position of these two marks individually and in parallel, and the optical system becomes undesirably complicated.

Also, in order to detect the position of two marks in parallel in this sort of two-beam interference method, it is necessary that the detection position of the reticle mark and the wafer mark be spatially offset from their conjugate position relationship so that interference light from the reticle mark and the wafer mark do not become intermixed. As a result, the light paths of light beams incident upon two marks and the light paths of interference light from the two marks are not identical. The effect of air fluctuations and so forth on these two marks vary, which causes detection error.

Additionally, in recent years excimer laser light from KrF excimer lasers (wavelength 248 nm) or ArF excimer lasers (wavelength 193 nm) has been used as the exposure light. However, even in these cases red light with wavelength of about 600-800 nm from He-Ne lasers or semiconductor lasers, is being used as the alignment light. As a result, a large chromatic aberration occurs in the alignment light in the projection optical system (axial chromatic aberration, magnification chromatic aberration, etc.) and this must be corrected in order to do the TTR type of alignment. In particular, when there is relative positional displacement between a reticle mark and a wafer mark with uncorrected magnification chromatic aberration, the positional deviation of the alignment light and the positional deviation of the exposure light are different. This causes detection error. For example, if the wavelength of the exposure light is 248 nm, a magnification error of 5% occurs in the alignment light in the projection optical system. In this case, if the positional deviation of the two marks in alignment light is 2 $\mu$m, the positional deviation in exposure light is 2.1 $\mu$m (or 1.9 $\mu$m), so the detection error can be as much as 0.1 $\mu$m (100 nm).

Regarding this, the two-beam interference type alignment sensor disclosed in Japanese Laid-Open Patent Hei 4-7814 takes into account magnification error with regard to alignment light in the projection optical system, and adjusts the pitch of the interference fringe of the two light beams irradiating the reticle mark and the pitch of the interference fringe of the two light beams irradiating the wafer mark. To be specific, this means that the reticle mark and the wafer mark are provided with their respective independent detection systems, and the observation magnification of the reticle mark and the wafer mark are changed. Nevertheless, having two optical systems with different observation magnifications for the reticle mark and the wafer mark in this manner makes the entire optical system complicated and undesirably increases the manufacturing cost.

Summary of the Invention

An object of the present invention is a heterodyne interference-type alignment sensor that permits the high-precision matching of detection light beams to the pitch of the diffraction grating mark to be detected without introducing undue complexity to the optical system.

Another object of the present invention is a heterodyne interference-type alignment sensor that can rapidly and in real time respond to diffraction grating marks of different pitches.

A further object of the present invention is a heterodyne interferometric apparatus driven by low power to generate light beams that are frequency modulated with a high diffraction efficiency.

Yet another object of the present invention is a position detecting apparatus and method that accurately detects the positional deviation of a reticle mark and a wafer mark via a simple optical system using light beams advancing along light paths that are as close as possible when detecting positional deviation of the two marks using alignment light of a predetermined wavelength.

It is to be understood that both the foregoing general description and the following detailed description are exemplary and explanatory and are intended to provide further explanation of the invention as claimed.

Additional features and advantages of the present invention will be set forth in the description that follows and in part will be apparent from the description or may be learned by practice of the invention. The objects and other advantages of the invention will be realized and attained by the structure particularly pointed out in the written description and claims hereof as well as the appended drawings.

To achieve these and other advantages and in accordance with the purposes of the present invention, as embodied and broadly described, an alignment apparatus for an exposure apparatus that transfers the image of a reticle onto a developing surface through the use of a first light beam having a first frequency, a second light beam having a second frequency different from the first frequency, an objective optical system to condense the first light beam and the second light beam and to direct the condensed light beams onto a first diffraction grating mark on the reticle and onto a second diffraction grating mark on the developing surface at two predetermined angles, and a detector that photoelectrically detects interference light formed by beams that are diffracted from the diffraction grating mark, such that the alignment apparatus detects the position of the diffraction grating marks based upon the output signals from the detector comprises a light source to project light beams along an optical path, an acousto-optic modulator disposed on the optical path of the light beams emanating from the light source, and a modulator driver to apply ultrasonic waves having variable frequencies to the acousto-optic modulator to cause the acousto-optic modulator to produce two light beams having different frequencies from each other from the light beams emanating from said light source.

In another aspect, the present invention contemplates an alignment apparatus for aligning a reticle with shot areas of a photosensitive surface by detecting the positions of diffraction grating marks, comprising a light source for projecting two light beams of different frequencies along an optical path, an objective optical system on the optical path to converge the two light beams and to direct the converged light beams to diffraction grating marks on the reticle and the photosensitive surface, a photoelectric detector for detecting interference among light beams diffracted by the diffraction grating marks, and an acousto-optical modulator for splitting light beams from the light source into two light beams of different frequencies by an anisotropic diffraction method and for directing the two light beams in different directions.

Another aspect of the present invention is a position detecting method to detect positional deviation between a grating-shaped alignment mark on a mask and a grating-shaped alignment mark on a photosensitive substrate, comprising the steps of setting the pitch of the alignment mark on the mask and the pitch of the alignment mark on the photosensitive substrate so that diffracted light from the two alignment marks when illuminated with position detection light is not superimposed, and detecting the positional deviation of the two alignment marks based on the phase of light diffracted from the two alignment marks obtained when the two alignment marks are simultaneously illuminated with the position detection light.

The present invention further includes a position detecting apparatus for use with an apparatus for copying a pattern formed on a mask onto a photosensitive substrate with illuminating light for exposure, the position detecting apparatus using position detection light of a predetermined wavelength to detect positional deviation between a grating-shaped alignment mark on the mask and a grating-shaped alignment mark on the photosensitive substrate, comprising a light modulator to project two light beams with different frequencies, a drive to provide variable frequency ultrasonic waves to the light modulation means, an irradiation optical system to guide the two light beams from the light modulator to the projection optical system and to the alignment mark on the mask and to the alignment mark on the photosensitive substrate, and a detector to photoelectrically detect interference light formed by a plurality of combinations of diffracted light generated in the same direction from the two alignment marks and to adjust the ultrasonic wave frequency provided by the drive to the light modulator means according to the pitch of the alignment mark of the two alignment marks being detected.

## BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:

FIG. 1(A) is a schematic configuration of an embodiment of the projection apparatus of the present invention showing the alignment apparatus;

FIG. 1(B) is a schematic configuration of another embodiment of the projection apparatus of the present invention showing the alignment apparatus;

FIG. 2(A) is a plan view showing a diffraction grating mark and transparent window on a reticle;

FIG. 2(B) is a plan view showing a field aperture which is conjugate with a reticle;

FIG. 3(A) is a diagram showing a field aperture that is conjugate with a reticle;

FIG. 3(B) is a diagram showing a field aperture that is conjugate with a wafer;

FIG. 4 is a diagram showing the section in which two beams of different frequencies are generated by using two acousto-optical modulators in the apparatus of FIGs. 1(A) or 1(B);

FIG. 5 is a magnified diagram showing an example of the optical system that corrects for displacement of the intersection of two beams in the direction perpendicular to the optical axis;

FIG. 6 is a diagram showing a section which produces two light beams of different frequencies using two acousto-optical modulators in the apparatus of FIG. 1(B);

FIG. 7 is a diagram showing the relations of wave number vectors in isotropic Bragg diffraction;

FIG. 8 is a diagram showing the relations of wave number vectors in anisotropic Bragg diffraction;

FIG. 9 is a configuration of the two light beam producing device of the alignment sensor of the present invention;

FIG. 10(A) is a diagram showing how light beams generated from AOM change their direction at different angles after diffraction;

FIG. 10(B) is a diagram showing how light beams illuminated on a diffraction grating mark change their angles of incidence according to the diffraction grating mark to be detected;

FIG. 11 is a configuration of AOM used in the present invention;

FIG. 12 is a configuration showing a modified two beam embodiment;

FIG. 13 is a configuration showing a modified example in which a relay optical system is located between the two acousto-optical modulators of FIG 12;

FIG. 14 is a configuration of the two light beam producing means of the alignment sensor another embodiment of the present invention;

FIG. 15 is a diagram showing a modified example in which a relay optical system is located between the two acousto-optical modulators;

FIG. 16 is a diagram showing a configuration of a two beam producing section in the alignment apparatus of the present invention;

FIG. 17 is a configuration showing a light source means having a plurality of light sources which provide light of different wavelengths and a reflection type diffraction grating of a sawtoothed shape;

FIG. 18(A) and 18(B) are explanatory drawings for detecting the position of reticle mark 14X and wafer mark 16X by the time sharing method;

FIG. 19 is a schematic structural drawing showing one example of an embodiment of a projection exposure apparatus according to the present invention;

FIG. 20(A) is a plan drawing showing the arrangement of reticle marks on reticle R in FIG. 19;

FIG. 20(B) is an enlarged plan drawing showing the arrangement of wafer marks provided in one shot region on wafer W in FIG. 19;

FIG. 21 is a drawing providing an explanation of the pitch relationship between a reticle mark and a water mark in one embodiment of the present invention;

FIG. 22(A), 22(B), and 22(C) are drawings showing variations of the reticle marks used in one embodiment of the present invention; and

FIG. 23(A) and 23(B) are drawings showing another embodiment of the present invention.

## DETAILED DESCRIPTION OF THE PREFERRED EMBODIMENTS

Reference will now be made in detail to the preferred embodiments of the present invention, examples of which are illustrated in the accompanying drawings.

In the alignment apparatus of the present invention, two light beam generators generate two light beams having different frequencies from each other. An objective optical system condenses the two light beams from the two light beam generators and directs them to diffraction grating marks RM, WM that are formed on a reticle and a wafer. A detector photoelectrically detects the interference light beams produced by the diffracted beams generated by the diffraction grating marks RM, WM.

The two light beam generators are provided with a light-source that supplies either monochrome light beams or light beams ($L_0$) containing light beams of multiple wavelengths, one or more acousto-optic modulators disposed on the light path for the light beams produced by the light source and a drive mechanism that applies ultrasonic waves of variable frequencies to the acousto-optic modulator. The application of ultrasonic waves of variable frequencies by the drive mechanism to the acousto-optic modulator causes the light beams ($L_0$) from the light source to generate, through the acousto-optic modulator, two light beams ($L_1(1)$, $L_2(-1)$) having different frequencies from each other.

According to the present invention, the acousto-optic modulator has a structure such that any ultrasonic progressive waves inside the acousto-optic modulator are substantially conjugate with the diffraction grating marks, RM, WM. This allows for the variation of the frequency of the ultrasonic waves that are applied by the acousto-optic modulator to the acousto-optic medium. In this case, ultrasonic waves with a frequency f1 are applied to the acousto-optic medium. If A1 denotes the wavelength of the progressive waves in the acousto-optic medium and V denotes the speed of sound, the following equation holds:

$$A1 = V/f1 \qquad (1)$$

Therefore, by varying the frequency of the ultrasonic waves that are applied, wavelength A1 of the progressive waves, i.e., the pitch of the progressive waves, can be changed according to Equation (1). In other words, by regulating the frequency of the ultrasonic waves, it is possible to match easily the pitch of the progressive waves to the pitch of the diffraction grating marks, RM, WM, and consequently the pitch for the interference fringes due to the two light beams ($L_1(1)$, $L_2(-1)$) that are generated through the acousto-optic modulator (matching in terms of a predetermined magnification factor). In this manner, positions can be detected with a high degree of precision. For example, if the objective optical system located between the acousto-optic modulator and the diffraction grating marks RM, WM, contains a magnification factor error, the pitch of the progressive waves can be controlled by simply correcting the magnification factor error.

In this case, the drive mechanism, for example, changes the frequency of the ultrasonic waves applied to the acousto-optic modulators according to the pitch of the diffraction grating marks, RM, WM. This enables the apparatus to respond rapidly and virtually in real time to diffraction gratings that have different pitches.

At least one of the acousto-optic modulators should preferably be composed of a medium that generates anisotropic Bragg diffraction. An explanation of anisotropic Bragg diffraction follows.

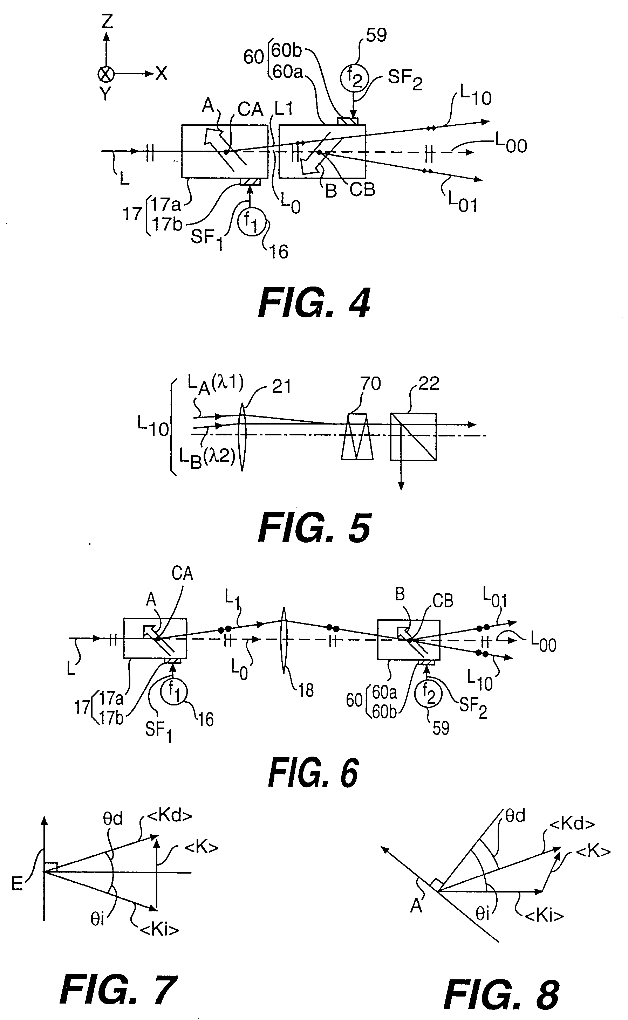

FIG. 7 shows diffraction due to normal isotropic Bragg diffraction. In FIG. 7, the ultrasonic progressive wave E is a longitudinal wave with a wave number vector (K) being parallel to the direction of propagation. If $\theta i$ denotes the incident angle of the incident light and $\theta d$ denotes the diffraction angle of the diffraction beam, ⟨Ki⟩ denotes the wave number vector for the incident light, and ⟨Kd⟩ denotes the wave number vector for the diffracted beams, the following equation holds:

$$\langle Kd \rangle = \langle Ki \rangle + \langle K \rangle \qquad (2)$$

In isotropic Bragg diffraction, the direction of polarization of the diffracted beams does not change, and the absolute value Ki of the wave number vector ⟨Ki⟩ and the absolute value of the wave number vector ⟨Kd⟩ are equal to each other. Therefore, incident angle $\theta i$ and diffraction angle $\theta d$ are equal to each other.

In contrast, FIG. 8 shows diffraction by anisotropic Bragg diffraction. In this figure, the ultrasonic progressive wave A is a transversal wave with a wave number vector ⟨K⟩ that intersects the direction of propagation at a predetermined angle. Also in this case, the relationship expressed by Equation (2) holds between wave number vector ⟨Ki⟩ for the incident light (assumed to be linearly polarized) and wave number vector ⟨Kd⟩ for the diffracted beams.

It should be noted that in anisotropic Bragg diffraction, the direction of polarization of the diffracted beams rotates by a predetermined angle (e.g., 90°) with respect to the direction of polarization of the incident light, such that refractive index ni in the direction of polarization of the incident light differs from the refractive index nd of the direction of polarization of the diffracted beams. If $\lambda$ denotes the wavelength of the incident light in a vacuum, the absolute values ⟨Ki⟩ and ⟨Kd⟩ of the wave number vectors ⟨Ki⟩ and ⟨Kd⟩ can be expressed, respectively, by the following formulas, where Ki and Kd are different:

$$Ki = 2pni/\lambda, \quad Kd = 2\pi nd/\lambda \qquad (3)$$

If Equation (2) is to be satisfied under these conditions, as shown in FIG. 8, incident angle $\theta i$ is different from diffraction angle $\theta d$. This is anisotropic Bragg diffraction. In this case, if the direction of polarization of the incident light has rotated from the condition depicted in FIG. 7, the absolute value Ki of wave number vector ⟨Ki⟩ changes, and so does the absolute value Kd of the wave number vector ⟨Kd⟩ of the diffracted beams. This virtually eliminates the possibility of the existence of diffracted beams that satisfies Equation (2). The result is that the diffraction efficiency changes substantially according to the direction of polarization of the incident light, and produces an anistropicity in diffraction efficiency.

Thus, in cases where the diffraction efficiency of an acousto-optic modulator is anisotropic, frequency modulation at low drive power and high diffraction efficiency can be effected by setting the direction of polarization and the incident angle of the light incident upon the acousto-optic modulator in a direction that maximizes the diffraction efficiency.

With regard to the light beams that do not require frequency modulation in the acousto-optic modulator, the direction of their polarization should be set in a direction that minimizes the diffraction efficiency and the incident direction should also be varied. This causes two light beams of different frequencies to be emitted in different directions, the result being that it is possible to direct the two light beams easily onto diffraction grating marks at a desired angle of intersection through an objective optical system that is provided downstream from the acousto-optic modulator. Furthermore, because in the present invention the frequency of the ultrasonic waves that are applied to the acousto-optic modulator is variable. Even at low drive power, the pitch of the progressive waves in the acousto-optic modulator can easily be matched to the pitch of the diffraction grating marks. Also, by using anisotropic Bragg diffraction, the range can be increased over which the diffraction angle of the diffracted beams from the acousto-optic modulator may be varied (i.e., the variation range of the frequency of the ultrasonic waves to be applied can be broadened).

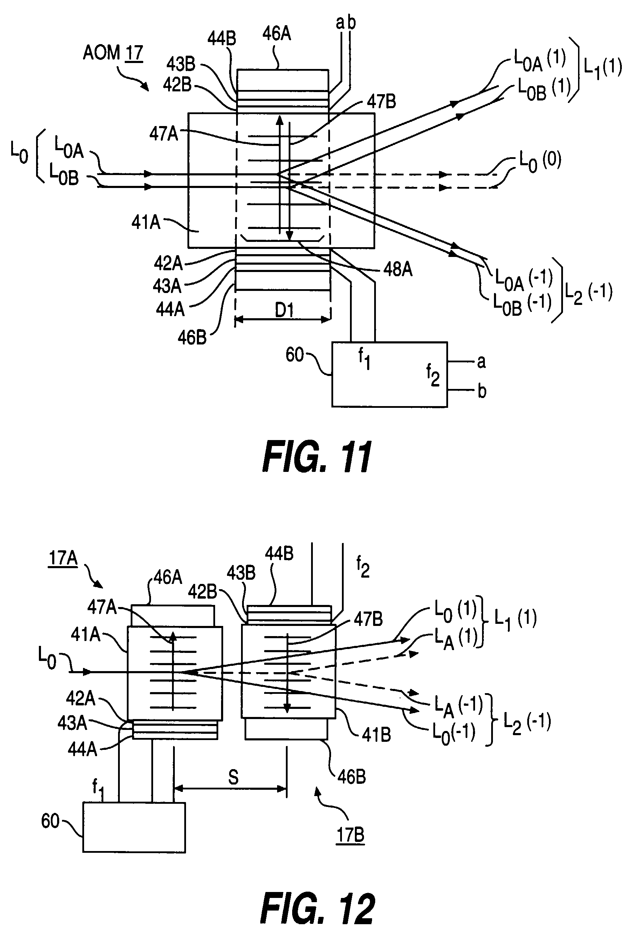

In the alignment sensor of the present invention, at least one of the acousto-optic modulators can be made of a medium that generates a Raman-Nath diffraction. The term Raman-Nath diffraction refers to the phenomenon in which, as shown in FIG.11, the light beams ($L_0$) falling incident upon ultrasonic waves (47A, 47B) from an angle parallel to the wave front is diffracted symmetrically into ±1st order diffracted beams ($L_1(1)$, $L_2(-1)$) centered on the 0-order light beams ($L_0(0)$).

Generally, the drive frequency of an acousto-optic modulator is on the order of 10 MHZ. The signal processing system that processes this frequency as the frequency difference between the two light beams, i.e., the beat frequency of a heterodyne beam that is obtained from the diffraction grating marks, is necessarily complex. To circumvent this problem, Raman-Nath diffraction is employed so that ultrasonic waves of variable frequencies having a predetermined frequency difference are applied to two locations in one acousto-optic modulator. In this manner, a pair of light beams having a beat-down frequency difference which can easily be processed, can be extracted from the acousto-optic modulator.

Preferably, the drive mechanism should be able to apply ultrasonic waves of variable frequencies and with a constant frequency difference to locations in the acousto-optic modulator. A variable frequency of the ultrasonic waves that is applied to the acousto-optic modulator will necessarily make variable the frequency difference between the resulting two light beams, i.e., the beat frequency. This results in undue complexity for the signal processing system. To circumvent this problem, in order to accommodate diffraction grating marks of different pitches, for example, ultrasonic waves of variable frequencies and with a constant difference frequency (beat frequency) are applied to two locations in one or more acousto-optic modulators while holding the beat frequency constant.

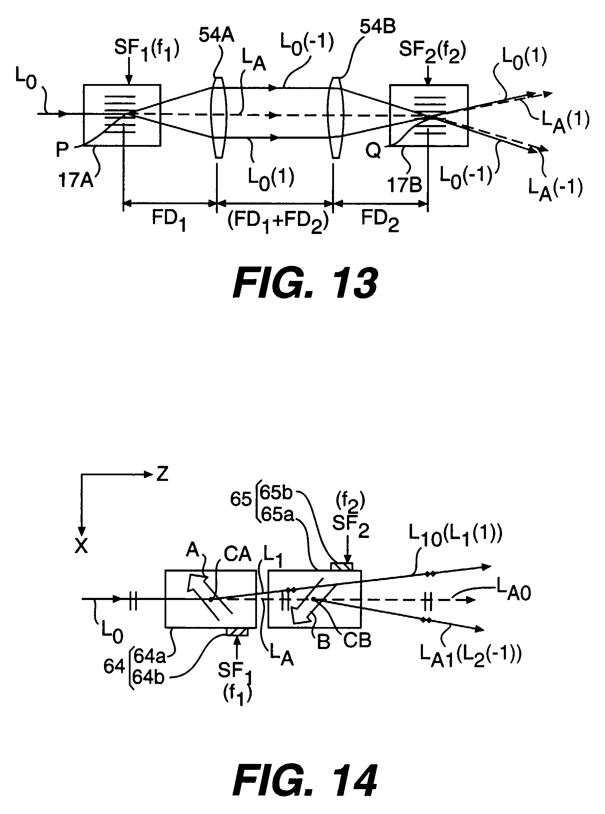

Specifically, as shown in FIG. 13, two acousto-optic modulators 17A, 17B are either placed close to each other in tandem or disposed through a relay system. Ultrasonic waves of a frequency f1 that satisfy Equation (1) are applied to the first acousto-optic modulator, and the frequency of the ultrasonic waves applied to the second acousto-optic modulator is set to f2. Then, frequency f2 is varied in conjunction with frequency f1 while holding the frequency difference (the beat frequency) $\Delta f$ constant, where the frequency difference is defined by the following equation:

$$\Delta f = f2 - f1 \qquad\qquad (4)$$

As in Equation (1), this generates, inside the second acousto-optic modulator 17B, progressive waves of pitch A2, where A2 is defined by the following equation:

$$A2 = V/f2 \qquad\qquad (5)$$

If $\Delta f$ is sufficiently small compared with frequency f2, f1 and f2 are virtually equal. Consequently, in this case the pitches A1 and A2 of progressive waves are virtually equal. In this manner, the pitch of the progressive waves can be changed while holding the beat frequency constant. Also, the beat frequency $\Delta f$ can be made small in order to facilitate signal processing.

The exposure apparatus of the present invention is equipped with an alignment sensor of the present invention and with a stage that moves the photosensitive substrate on which a diffraction grating mark WM is provided in each of the shot regions. The exposure apparatus transcribes mask patterns onto the photosensitive substrate that has been position-aligned by the stage. The position of a diffraction grating mark WM on the photosensitive substrate is detected by means of the alignment sensor, and the photosensitive substrate is aligned by moving the stage based upon the results of the detection. According to the alignment sensor of the present invention, mask patterns are transcribed after the photosensitive substrate is aligned based upon the position of the diffraction grating mark WM that was detected through the alignment sensor.

When an acousto-optical modulator is anisotropic, setting of the polarized direction and the angles of incidence of the incoming beams can provide maximum diffraction efficiency if they are set in appropriate directions. Thus, the acousto-optical modulator can be driven with low power and provide frequency modulation at a high {diffraction} efficiency. In addition, regarding those light beams that do not require frequency modulation by the acousto-optical modulator, setting of their polarized direction can be directed to minimize the diffraction efficiency. Also, changing the angle of incidence can direct two light beams of different frequencies in different directions. It is easy to direct these two light beams to diffraction grating marks RM, WM via the objective optical system at a desired angle of intersection.

In this case, the two light beam generators comprise two acousto-optical modulators receiving ultrasonic waves which have anistropic diffraction efficiencies and different frequencies. The diffracted light beams ($L_{10}$, $L_{01}$) from these two acousto-optical modulators are directed to different directions. It is ideal that the diffracted light beams that are directed in different directions are guided to the objective optical system as two light beams of different frequencies.

Incoming light (L) is split into zeroth order beams ($L_0$) and 1st order beams by a first acousto-optical modulator. The zeroth order light beams ($L_0$) produced are diffracted into the 1st order beams such that the present 1st order light beams are diffracted with a larger diffraction efficiency with respect to the acousto-optical modulator, to which an ultrasonic wave of frequency $f_2$ is applied. The present 1st order diffracted light beams and the previous 1st order diffracted light are directed in non parallel directions.

When diffraction efficiencies are anisotropical as is the case in the anisotropic Bragg diffraction method, the direction in which the zeroth order beams ($L_0$) are polarized is rotated from the direction that the 1st order beams ($L_1$) are polarized by a first acousto-optical modulator. At the same time, the angle of incidence of the zeroth order beams ($L_0$) and that of the 1st order beams ($L_0$) on a second acousto-optical modulator are different. Therefore, if a large diffraction efficiency is set for the zeroth order beams ($L_0$) in the second acousto-optical modulator, the diffraction efficiency for the 1st order beams ($L_1$) becomes negligible, thus almost simply transmitting the 1st order beams ($L_1$). As a result, at the second acousto-optical modulator, the 1st order beams are diffracted at a high efficiency with respect to the zeroth order beams $L_{01}$ and the zeroth order beams are diffracted at a high efficiency with respect to the 1st order beams. The 1st order diffracted light beams ($L_{01}$) are frequency modulated at $f_2$ and the zeroth order beams ($L_{10}$) are frequency modulated at $f_1$. Both light beams are polarized in the same direction at a given angle with respect to incoming light (L).

If the 1st order diffracted light beams ($L_{01}$) and the zeroth order beams, interfere with each other, and a beat frequency ($f_1$ - $f_2$) generates interference beams. This can provide heterodyne beams with frequencies that are easy to process electronically. Also, the 1st order diffracted light beams ($L_{01}$) and the zeroth order diffracted light beams ($L_{10}$) are directed mutually symmetrical by the two acousto-optical modulators. Even if white light or light beams of a plurality of frequencies are used as incoming light, light optical beat signals of a high SN ratio can be obtained.

A relay optical system may be installed between the two acousto-optical modulators such that the ultrasonic wave operating region of the first acousto-optical modulator is conjugate with that of second acousto-optical modulator and ultrasonic waves of different frequencies may be applied to the two acousto-optical modulators in such a conjugate relationship. With this configuration, two light beams of different frequencies are generated in symmetry with respect to the optical axis. These two light beams can be illuminated onto the diffraction grating marks at a desired angle of desired incidence.

The two acousto-optical modulators may be installed adjacent to each other, and ultrasonic waves of different frequencies may be applied in the inverse direction to the two acousto-optical modulators.

In addition, it is preferable that the first acousto-optical modulator, produces the zeroth order beams and the 1st order beams in a substantially equal ratio with respect to the incoming light beams. It is also preferable that the second acousto-optical modulator is given a diffraction efficiency such that it maximizes diffraction of the 1st order beams with respect to the zeroth order beams diffracted by the first acousto-optical modulator. The contrast at the first acousto-optical modulator can be adjusted by tuning the ultrasonic wave power. Beams other than the 0 and 1st orders are diffracted so weakly that the light beams which have two different frequencies can be produced at an even intensity very efficiently.

It is preferable that at least one of the two acousto-optical modulators in the two light beam producing means is made of a medium which causes anisotropic Bragg diffraction. With anisotropic Bragg diffraction, the sonic speed in the medium become slower than that of the isotropic Bragg diffraction. This makes the ultrasonic wavelength relatively smaller, thus reducing the pitch between interference fringes generated by the two light beams. Thus, the cross sectional area of the region on a medium on which light beams fall and the ultrasonic wave operating region can be made relatively small, reducing ultrasonic power applied to the medium.

The exposure system of the present invention comprises the alignment apparatus of the present invention and a stage that aligns the photosensitive substrate for photoprinting mask patterns onto a photosensitive substrate. The position of diffraction grating mark WM on photosensitive substrate is determined by the alignment apparatus. Photosensitive substrate is aligned based on the detected data. In the exposure system of the present invention, photosensitive substrate is aligned based on the positional data of the diffraction grating mark WM provided by the alignment apparatus, then, the mask pattern is photoprinted on the photosensitive substrate.

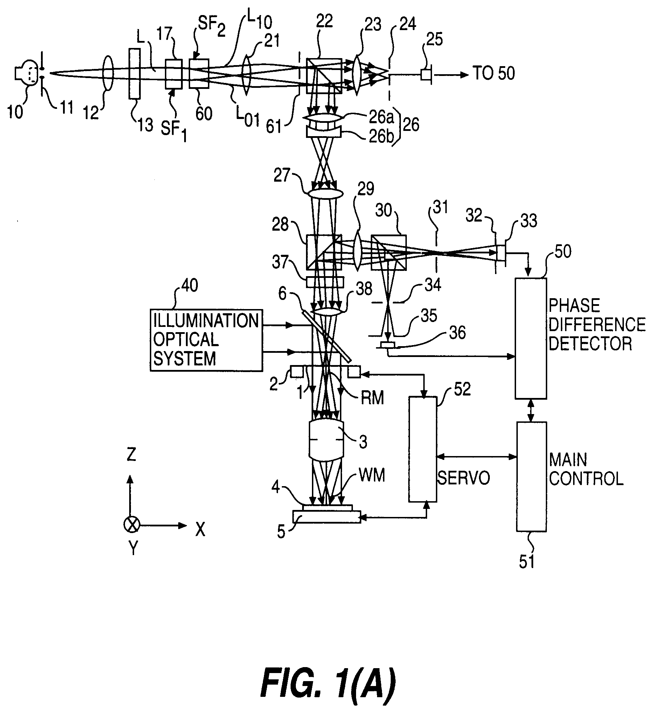

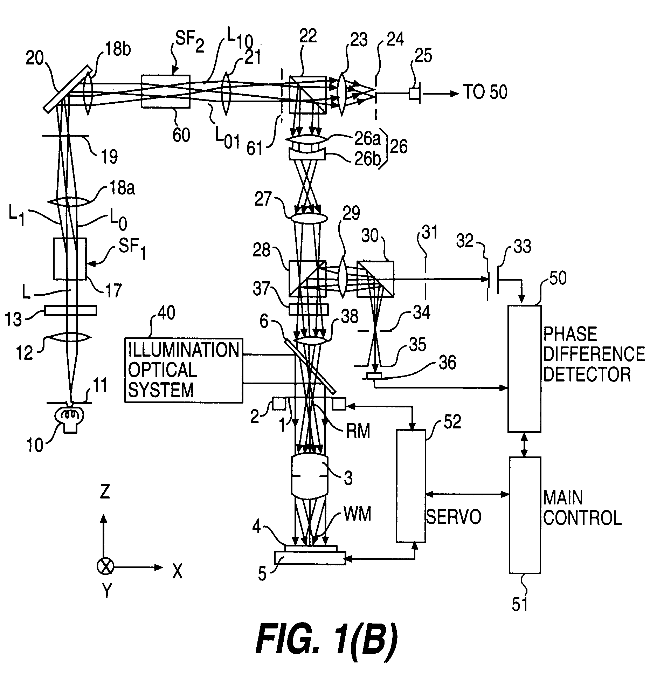

Figure 1(A) shows a simplified schematic representation of a projection exposure apparatus which has an alignment detector of the present invention. As shown in FIG. 1(A), reticle 1 is secured on stage 2, which is movable in two dimensions.
A circuit pattern for photoprinting is formed on the pattern surface of reticle 1. A diffraction grating reticle mark RM, which is an alignment mark (reticle mark), is formed near the circuit pattern.

Illumination optical system 40 is placed above the reticle at an angle. During exposure, exposure light from illumination optical system 40 is reflected downwardly by dichroic mirror 6, which is attached at a 45° angle above reticle 1 to illuminate the circuit pattern on reticle 1 with a uniform intensity distribution. Under the exposure light, the circuit pattern on reticle 1 is projection exposed onto each of the shot regions at a given projection magnification $\beta$ via projection optical system including projection object lens 3.

The surface of a wafer 4 is coated with photoresist which is secured on the surface and is conjugate to the pattern surface of reticle 1 with respect to projection optical system 3. Also, a diffraction grating wafer mark (WM) of the same kind as the diffraction grating reticle mark RM on reticle 1 is formed near each of the shot regions on wafer 4. For the following discussion, the Z axis is defined to lie parallel to the optical axis of projection optical system 3, the x axis to lie in a plane perpendicular to the Z axis and parallel to the page, and the Y axis to be perpendicular to the page.

Wafer 4 is loaded onto a wafer stage 5, which moves in two dimensions, i.e., the X and Y directions. Once a pattern on reticle 1 is exposed for photoprinting in a shot region, the next shot region, which is to be exposed, is stepped to the exposure field of the projection optical system 3. Interferometers not illustrated are installed for measuring rotation ($\theta$) directions in the X axis and the Y axis on wafer stages 2 and 5 independently. A drive motor drives each of the stages in each of the directions.

An alignment optical system for measuring the location of diffraction grating marks RM and WM is installed above the dichroic mirror 6. In this alignment optical system, light source 10 such as a halogen or xenon lamps supplies white light of different wideband from exposure light. White light from light source 10 is converted to parallel beams by variable aperture 11, which is capable of changing its diameter, and condenser lens 12, and, is introduced into the first AOM 17 via band pass filter 13, which extracts light of a given wavelength band.

Beam L, which is linearly polarized in parallel with the page on which FIG. 1(A) is drawn and along the Z axis direction, is introduced into the first AOM 17, and then introduced into the second AOM 60.

The first AOM 17 is driven by $SF_1$, which is a high frequency signal of frequency $f_1$. The second AOM 60 is driven by $SF_2$, which is a high frequency signal of frequency $f_2$ ($<f_1$) in the reverse direction. Frequencies $f_1$, $f_2$ each are set to be several tens of MH and the frequency difference ($f_1-f_2$) is several tens of KH. In addition, beam L is affected by anisotropic Bragg diffraction in AOM 17 and AOM 60 in that order. In AOM 17 and 60, the laser beams L are frequency modulated, being effected by the anisotropy Bragg diffraction, and emitted as beams $L_{10}$, which obtained $f_1$ frequency modulation in AOM 17, and beams $L_{01}$, which obtained $f_2$ frequency modulation in the second AOM 60.

Beams $L_{10}$ and $L_{01}$ 60 are condensed by lens 21 such that principal rays are nearly parallel to the optical axis, and are passed through spatial filter 61, which shields unwanted diffracted light. The beams are directed to beam splitter 22 to be split into two. Beams $L_{01}$ and $L_{10}$, which are transmitted through beam splitter 22 are condensed by lens 23 onto diffraction grating 24, which is installed at the point where condensation takes place. Interference fringes are formed in the pitch direction.

The diffracted light beam, which has passed through diffraction grating 24, is photoelectrically detected in the photodetector 25 which comprises a photodiode, etc. as a optical beat signal.

On the other hand , beams $L_{01}$ and $L_{10}$ reflected by beam splitter 22 pass through relay optical system 26 (which consists of lens 26a, 26b), relay lens 27, beam splitter 28, and parallel-plane plate 37. Parallel-plane plate 37 is installed at the plane which is conjugate with the pupil of projection optical system 3 or its vicinity, such that its inclination angle is variable to the optical axis of the alignment optical system, having a function to maintains the system telecentric. The parallel-plane plate 37 may be replaced by a combination of a thick parallel-plane plate for coarse adjustment and a thin parallel-plane plate for fine adjustment.

Beams $L_{01}$ and $L_{10}$ which pass through parallel-plane plate 37 then pass through objective lens 38 and the dichroic mirror 6 to illuminate the diffraction grating mark RM on reticle 1 from two directions at a given cross angle.

In the case that the projection optical lens 3 is not achromatic to the alignment light, its objective lens is preferably a bifocal optical system as proposed in Kokai 63-283129. By doing so, the two beams entering the bifocal optical system are split respectively into two polarized light components perpendicular to each other. One of the polarized light components from each beam is directed toward the first focus is converged on the reticle, while the other of the two polarized light components from each beam is directed toward the second focus is converged on the wafer.

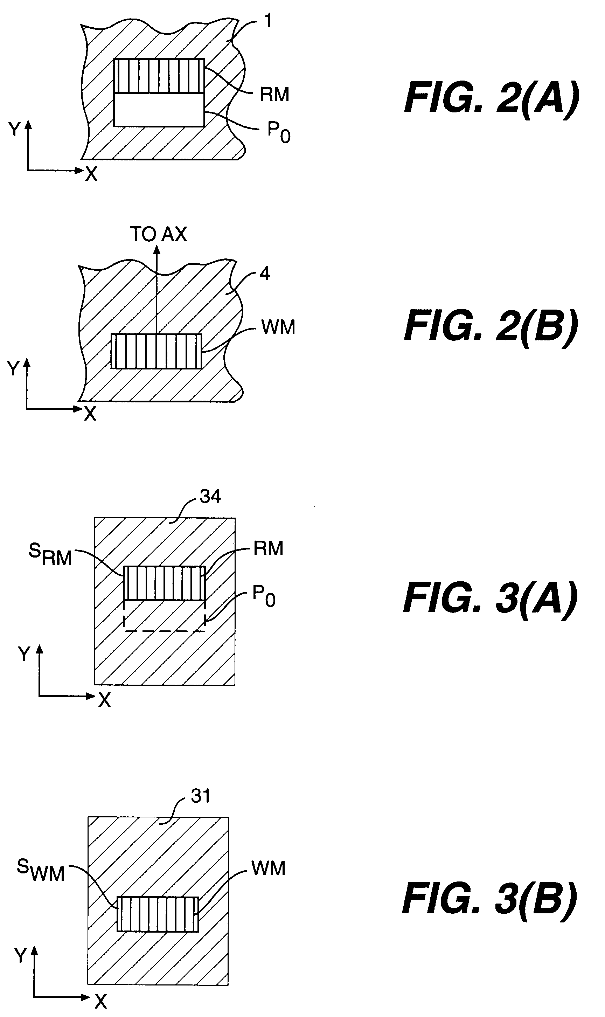

As beams $L_{01}$ and $L_{10}$ illuminate diffraction grating reticle mark RM on a reticle, the reticle 1 has an alignment light transmitting window $P_0$ next to the diffraction grating mark RM, as shown in FIG. 2 (A) and the diffraction grating mark WM is formed at the position corresponding to the transmitting window $P_0$ on the wafer, as shown in FIG. 2 (B).

The beams $L_{01}$ and $L_{10}$ are arranged to illuminate the diffraction grating mark RM from the two directions with a cross angle satisfying the following equation.

$$\text{Sin } \theta_{RM} = \lambda_0/P_{RM} \qquad (6)$$

where,

$P_{RM}$:　is the pitch of the diffraction grating mark RM,
$\lambda_0$:　is a base wavelength of light emitted from the light source 10,
$\theta_{RM}$:　is an incident angle of beam $L_{01}$ or beam $L_{10}$ onto diffraction grating RM.

By this, the ± 1st order diffracted light beams from diffraction grating reticle mark RM are guided to pass again through dichroic mirror 6, objective lens 38, and the parallel-plane plate 37. After that, the 1st order diffracted light beams are reflected by beam splitter 28 to pass through lens 29 and a beam splitter 30 to a field aperture 34.

Field aperture 34 is located conjugate with reticle 1. As shown in FIG. 3(A), field aperture 34 has an opening portion $S_{RM}$ at the position corresponding to diffraction grating mark RM to permit only diffracted light from diffraction grating mark RM on reticle, as indicated by vertical lines in FIG. 3(A).

Then, the diffracted light from diffraction grating mark RM, pass through field aperture 34 and is filtered by spatial filter 35 for cutting zeroth order diffracted light beams, so that only ±1st order diffracted light beams reach detector 36. The photoelectric detector 36 photoelectrically detects an optical beat signal including information on the position of reticle 1.

A part of beams $L_{01}$ and $L_{10}$, passing through the transparent window $P_0$ of reticle 1, illuminates through projection optical system 3 diffraction grating wafer mark WM on wafer 4 in two directions with a given cross angle so that interference fringes flowing along the pitch direction are formed on diffraction grating mark WM. The -1st order diffracted light beams of beam $L_{01}$ and the +1st order diffracted light beams beam L10 are made to advance in the direction normal to diffraction grating mark WM (along the optical axis of projection objective lens 3).

Beams $L_{01}$ and $L_{10}$ are arranged to illuminate the diffraction grating mark RM in two directions with a cross angle satisfying the following equation:

$$\text{Sin } \theta_{WM} = \lambda_0/P_{RM} \qquad (7)$$

where

$P_{RM}$:　is the pitch used in the diffraction grating mark WM.
$\lambda_0$:　is a base wavelength of light emitted from light source 10,
$\theta_{WM}$:　is an incident angle of beams $L_{01}$ and $L_{10}$ onto diffraction grating WM.

The ±1st order diffracted light beams from diffraction grating wafer mark WM passes again through projection objective optical system 38, transparent window $P_0$ (FIG. 2(A)), dichroic mirror 6, objective lens 38, and parallel-plane plate 37 and are reflected by beams splitter 28 to pass through beam splitter 30 to reach field aperture 31. Field aperture 31 is located conjugate with wafer 4. Specifically, field aperture 31 has an opening portion $S_{WM}$ at the position corresponding to the diffraction grating mark WM to permit only diffracted light from the diffraction grating mark WM on wafer 4 to pass through, as indicated by vertical lines in FIG. 3(A).

The diffracted light from grating wafer mark WM passing through field aperture 31 is filtered by spatial filter 32 for cutting zeroth order diffracted light beams, so that only ± order diffracted light beams reach photoelectric detector 33. The photoelectric detector 33 photoelectrically detects the light optical beat signals including positional information on position of wafer 4.

Each of the spatial filters 32, 35 is located at a position approximately conjugate with the pupil of the alignment optical system, that is, substantially conjugate with the pupil (exit pupil) of projection optical system 3 so that the zeroth order diffracted light beams (regular reflection light) from diffraction grating marks RM, WM formed on reticle 1 and wafer 4 respectively are interrupted and that only the ±1st order diffracted light beams (diffracted light advancing perpendicular to the diffraction grating marks on reticle 1 or wafer 4) can pass therethrough. In addition, each photo detector 33 and 36 is disposed approximately conjugate with reticle 1 or wafer 4 with respect to objective lens 38 and lens 29, respectively.

In the arrangement of the alignment optical system as described above, each of the three photoelectric signals obtained by the photoelectric detectors 25, 33, 36 includes a sinusoidal optical beat signal of the same frequency

$$\Delta f = (f_1 - f_2).$$

An optical beat signal extracting portion (Fourier transformation circuit) in phase difference detector 50, shown in FIG. 1(A), effects the Fourier transform electrically on the three photoelectric signals, whereby the three sinusoidal optical beat signals of frequency $\Delta f$ are extracted at excellent precision.

If reticle 1 and wafer 4 are stopped at arbitrary respective positions before being aligned, then the optical beat signals will have a certain phase difference. A phase difference of ±180° between the optical beat signals from reticle 1 and from wafer 4 is uniquely correspondent to a displacement amount of relative positions within a half of the grating pitch of diffraction grating marks formed on each of reticle 1 and wafer 4.

Thus, as the reticle 1 is moved relative to wafer 4 in the direction of grating arrangement, pre-alignment is carried out at a precision of below a half of the grating pitch of the diffraction grating marks RM, WM and then a main control system 51 performs alignment by two-dimensionally moving reticle stage 2 or wafer stage 5 through a servo system 52 as to make a phase difference obtained by the phase difference detection system 50 equal to zero or a certain value, whereby high resolution position detection may be achieved.

Alternately, using the optical beat signal obtained by the detector 25 as a reference signal, the alignment may be conducted to make a phase difference equal to zero or a certain value between the reference signal and the optical beat signals from diffraction grating marks RM, WM. Also, a drive signal for driving the AOMs 17, 60 may be used as a reference signal.

Next, more specific configuration and modulation principles for producing two beams of different frequencies will be described based on FIG. 4 and FIG. 1(A).

FIG. 4 is a magnified diagram illustrating the two AOMs 17, 60 from FIG. 1(A). In FIG. 4, AOM 17 is made by attaching transducer 17b (e.g. piezoelectric element) onto acousto-optic modulator medium 17a made of, for example, $T_e0_2$, quartz, or $PbM_0O_4$, etc. High frequency signal $SF_1$, of frequency denoted $f_1$ is applied by vibrator 16 to the transducer 17b. In the same manner, AOM 60 is made by attaching transducer 60b onto acousto-optic modulator medium 60a, and high frequency signal $SF_2$ of frequency $f_2$ is applied by vibrator 59. Transducer 60b is attached opposite to transducer 17b.

In this case, when incoming beams L are assumed to progress in the +X direction, horizontal ultrasonic progressive wave A is supplied by transducer 17b to acousto-optic medium 17a in the direction such that the wave intersects with the X axis at the XZ plane (the plane parallel to the page on which FIG. 4 is drawn) at a given angle. A portion of the beam L is diffracted by the anisotropic Bragg diffraction method due to the effect of ultrasonic progressive wave A. In the same manner, horizontal ultrasonic progressive wave B is supplied by transducer 60b to acousto-optic medium 60a such that the wave intersects with the X axis at the XZ plane in symmetry with ultrasonic progressive wave A. A portion of the beam L is diffracted by the anisotropic Bragg diffraction method due to the effect of ultrasonic progressive wave B.

In the anisotropic Bragg diffraction method in this embodiment, of the beams diffracted in the direction of ultrasonic progressive wave A and beams diffracted in parallel to the plane (X plane) including the incidence direction of incoming beams, only the 1st order light beams are diffracted. The zeroth order beams are not diffracted. The diffraction direction of the 1st order diffracted light beam is rotated to be perpendicular to the incidence angle. Also the frequency of the zeroth order beam is not modulated but that of the 1st order beam is frequency modulated at $f_1$ ($f_1$ or $f_2$). In FIG. 4, beams L are diffracted in the Z direction, therefore, the zeroth order beam $L_0$ of beam L supplied by AOM 17 goes to AOM 60 with a polarized direction perpendicular to the page on which FIG. 4 is drawn. In this case, the first AOM 17 adjusts the intensity of ultrasonic progressive wave A such that the intensities of the zeroth order beams and the 1st order beam $L_1$ become almost the same. This makes the intensities of the beams other than the zeroth order beams and the 1st order beams to be extremely weak.

On the other hand, the second AOM 60 adjusts the intensity of ultrasonic progressive wave 13 such that beams incident in the +X direction and, at the same time, beams which are diffracted to be in parallel to the XZ plane, are 100% the 1st order diffracted light beams. In addition, the 1st order beams $L_1$ supplied by the first AOM 17 are given an angle at which Bragg diffraction will handily occur at the second AOM 60. Therefore, the zeroth order beams $L_0$ are almost 100% diffracted by AOM 60 to be the 1st order diffracted light beams $L_{01}$ modulated at $f_2$.

The 1st order diffracted light beams $L_1$ are directly transmitted by AOM 60 as the zeroth order beams $L_{10}$. Also, the 1st order diffracted beams $L_{01}$ are polarized by AOM 60 in the direction (the y direction) perpendicular to the page on which FIG. 4 is drawn. The zeroth order beam $L_{10}$ are also polarized in the y direction. With the above conditions, if the 1st order diffracted light beams $L_{01}$ interfere with the zeroth order beam $L_{10}$, heterodyne beams of $(f_1 - f_2)$ are obtained,

In the embodiment of FIG. 1(A), alignment is detected by the 1st order diffraction light (hereafter simply referred to as "beams"). Approximately 50% of the incoming beams L are modulated at $f_1$ to become beams $L_{10}$, approximately all the remaining beams are modulated at $f_2$ to become beams $L_{01}$, providing high diffraction efficiency. Also, white beams $L_{10}$ and $L_{10}$, being emitted from AOM 60, travel the alignment optical system in symmetry, and in parallel to each other. This method does not deviate the optical paths among these beams theoretically. In other words, interference of the two beams can be provided with beams with a short interferable distance like white beams. In addition, the two beams have identical waves. That is, the phase difference between the two beams is zero. This not only makes accurate alignment possible, but also provides a compact and easy -to-adjust apparatus. Furthermore, the fact that beams $L_{10}$ and $L_{01}$ belong to side-band-widths maintains overall intensity of diffraction of any wavelength but a specific wave length which may encounter interference with the thin photoresist layer on wafer 4, for example, or fading of diffracted light which is caused by the step height difference that exists in diffraction grating mark WM. This makes accurate position detection possible under any exposure conditions.

Now, the power consumption is estimated for the acousto-optic modulators 17a, 60a in FIG. 4 made of $TeO_2$ crystals. When the pitch of diffraction grating mark WM, the alignment mark on wafer 4, is 8µm, the size of the diffraction grating mark WM is 100µm; ultrasonic frequencies $f_1$, $f_2$ applied to AOM 17, 60 are approximately 40MH; and the acoustic speed is 640 m/sec., and the operating region for the ultrasonic device is approximately 200µm X 200µm. The ultrasonic power applied to acoustic-optic media of AOM 17, 60 is equal to or less than approximately 10mW each, i.e., equal to or less than approximately 20mW for the two media.

In the method in which two acousto-optic modulators using the isotropic Bragg diffraction method are connected in series, approximately 2 to 3W of total ultrasonic power is required. The acousto-optic modulator using the anisotropic Bragg diffraction method of this embodiment consumes approximately 1/100 of the above power. This reduces thermal deformation of the alignment optical systems shown in FIG. 1(A), increasing the alignment accuracy. In addition, heat generation at AOM 17, 60 is reduced significantly, thus the frequency of beams L can be modulated consistently and continuously.

Also, the two AOMs 17, 60 are installed at positions that are close to each other. Thus, the portion of the apparatus which generates beams of different frequencies can be made compact with a simple configuration. However, when the two AOMs 17, 60 are installed at the positions that are close to each other as shown in FIG. 4, the center CA of the ultrasonic operating region of AOM 17 and the center CB of the ultrasonic operating region of AOM 60 are displaced along the optical axis. Therefore, when beams $L_{01}$ and $L_{10}$ belong to wide-band (or plural wavelengths), the intersections between the two beams are displaced along the direction perpendicular to the optical axis. This can be prevented, for example, by allocating different photoelectric detectors for each given narrow wavelength band (or each wavelength) for detecting interference beams from diffraction grating marks.

Other than the above method, the displacement of the intersection between the two beams may be corrected by using a dispersion body as shown in FIG. 5. In FIG. 5, a direct-vision prism 70 is installed in the vicinity of the pupil plane (Fourier transformed optical surface) of the lens 21 and between the lens 21 and the beam splitter 22 shown in FIG. 1(A). In FIG. 1(A), it is assumed that beams $L_{10}$ include beams $L_A$ of wavelength $\lambda_1$, and beams $L_E$ of wavelength $\lambda_2$. In this modified embodiment, beams $L_A$, $L_B$ fall onto lens 21 with their displaced principal beams, which are corrected to stay on the same axis through direct-vision prism 70. In this way, the intersection between the two beams $L_{10}$ and $L_{01}$ in FIG. 4 are maintained at a constant position regardless of their wavelength. The contrast between the two heterodyne beams, which are derived from the two diffracted light beams generated by the two diffraction grating marks RM, WM, is maintained at a high level. This provides accurate alignment.

Next, a second embodiment of the present invention is described based on Figures 1(B) and 6. In this embodiment, a relay optical system is installed between AOM 17 and AOM 60 of FIG. 1(A). In Figures 1(B) and 6, the portions corresponding to Figures 1(A) and 4 are referred to the same and are not described in detail.

FIG. 1(B) is a schematic diagram of a projection exposure apparatus on this embodiment. In FIG. 1(B), white light beams from light source 10 are introduced to AOM 17 as beams L of a given wavelength polarized in the direction parallel to the page on which FIG. 1(B) is drawn via variable lens stop 11 through band pass filter 13, etc. AOM 17 is driven by high frequency signal $SF_1$ of frequency $f_1$. The zeroth order beams $L_0$ of beams L and the 1st order diffracted light beams $L_1$, which are frequency modulated at $f_1$, are emitted by AOM 17.

The zeroth order beams $L_0$ and the first order beam $L_1$ pass through lens 18a, mirror 20, lens 18b to reach the AOM 60, which is driven by a high frequency signal $SF_2$ of frequency $f_2$. At this time, the center of the ultrasonic operation region of AOM 17 is conjugate with that of AOM 60. Diffracted light other than the zeroth order beams $L_0$ and the 1st order beams $L_1$ are shielded by spatial filter 19. In this embodiment, diffracted light other than the zeroth order and the 1st order beams are so weak that spatial filter 19 may be eliminated.

AOM 60 is driven by high frequency signal $SF_2$ in the opposite direction from AOM 17 considering reversal projection by relay optical system 18a, 18b and mirror 20. As a result, the 1st order diffraction [alignment] beams $L_{01}$, which are modulated at $f_2$ by AOM by anisotropic diffraction, and the zeroth order [alignment] beams $L_{10}$ of the 1st order diffracted light beams $L_1$ diffracted by AOM 60 are emitted in different directions. The zeroth order beams $L_{10}$ are frequency modulated at $f_1$ and the zeroth order [alignment] beams $L_{10}$ are not. The zeroth order beam $L_{10}$ and the 1st order diffracted light beams $L_{01}$ together are polarized in the direction perpendicular to the page on which FIG. 1(B) is drawn.

The zeroth order beam $L_{10}$ and the 1st order beam $L_{01}$ pass through lens 21 and spatial filter 61 and are split into two beams by beam splitter 22. Each of the beams split by beam splitter 22 is detected by photoelectric detectors 25, 33, and 36, in the same manner as in the embodiment of FIG. 1(A), therefore details of this are not described.

Next, the portion which generates two beams of different frequencies is described based on FIG. 6. FIG. 6 is a simplified schematic diagram showing the configuration from the first AOM 17 through the second AOM 60 in FIG. 1(B). In FIG. 6, the relay optical system 18a, 18b in FIG. 1(B) is represented by relay optical system 18 and mirror 20 [in FIG. 1(B)] is eliminated in FIG. 6. Therefore, high frequency signal $SF_2$ of AOM 60 is applied in the opposite direction in which it is in FIG. 1(B). In FIG. 6, the center of the ultrasonic operating region (diffraction point) CA of AOM 17 and that (diffraction point) CB of AOM 60 are conjugate with the relay optical system 18.

Light beams L, which are diffracted parallel to the page on which FIG. 6 are drawn to enter AOM 17. Approximately 50% of them are diffracted due to the effect of the Bragg diffraction to become the 1st order diffracted light beams $L_1$. Most of the remaining light beams are transmitted through the AOM in parallel with the optical axis. The first order diffracted light beams $L_1$ are frequency-modulated at $f_1$ and they are polarized in the direction perpendicular to the page on which FIG. 6 is drawn. The direction in which the zeroth order beams $L_0$ are polarized is the same as that of the incidence. First order diffracted light beams $L_1$ and zeroth order diffracted light beams $L_0$ passing through relay optical system 18 fall onto AOM 60 such that they intersect each other at the center CB of the ultrasonic operating region in the acousto-optical medium 60a of the second AOM 60.

Approximately 100% of the zeroth order beams $L_0$ are diffracted by the ultrasonic progressive wave B in the acousto-optic medium of AOM 60 to become the 1st order diffracted light beams $L_{01}$ which are frequency-modulated at $f_2$. The 1st order diffracted light beams are transmitted through AOM 60 nearly as they are to become zeroth order beam $L_{10}$. In addition, the 1st order diffracted light beams $L_{01}$ are polarized in the direction, which is perpendicular to the page on which FIG. 6 is drawn by AOM 60, which is the same direction in which zeroth order beams $L_{10}$ are polarized. Therefore, the 1st order diffracted light beams (hereafter referred to as "light beams") $L_{10}$ can be used as alignment beams. Some zeroth order beams $L_{00}$ may be generated by the AOM 60, which diffracts zeroth order beam $L_0$ at times, but the zeroth order beams $L_{00}$ are shielded by spatial filter 61.

Also, in this embodiment, approximately 50% of light beam L which enter the AOM become light beams $L_{10}$ which are frequency adjusted at $f_1$. Most of the remaining light beams become light beams $L_{01}$ which are frequency-modulated at $f_2$. This provides excellent diffraction efficiency. In addition, the fact that centers CA, CB of the ultrasonic operating regions in AOM 17, 60 in this embodiment are conjugate with each other through relay lens 18 provides better symmetry for the wideband light beams $L_{10}$ and $L_{01}$, which are diffracted by AOM 60, than in the mode of the first embodiment. For this reason, even with wideband wavelengths, the heterodyne beams maintain contrast between them. This reduces the interference from the photoresist thin layer or the confusion caused by the step height differences that exist in diffraction grating mark WM and makes accurate alignment possible.

When acousto-optical medium 17a, 60a on AOMs 17, 60 is made of $TeO_2$, for example, the power consumed by the acousto-optic modulator can be reduced to approximately 1/100 of that consumed by the acousto-optic modulator of the [isotropic] Bragg diffraction method.

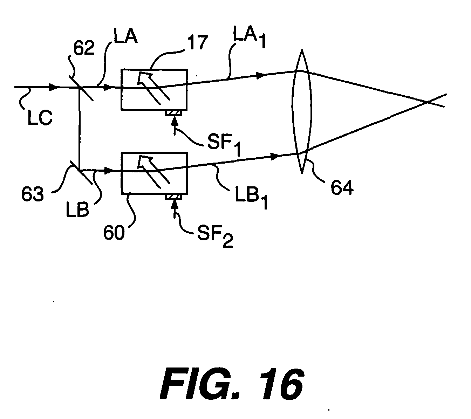

Next, the mode of the third embodiment is described based on FIG. 16. In this example also, the present invention is applied using TTR (through the reticle) and a heterodyne interferometric method sensor in a stepper-type projection exposure system. In FIG. 16, the portions that are identical to these in FIG. 4 are coded the same and they are not described in detail.

FIG. 16 shows the major section of the alignment apparatus of this example. As shown in FIG. 16, light beams of a single wavelength consisting of, for example, laser beams which are polarized in the direction parallel to the page on which FIG. 16 is drawn, enters half mirror 62. Light beams LA, which are transmitted by half mirror 62, enter the first AOM 17, which is driven by high frequency signal $SF_1$ of frequency $f_1$, and are then diffracted by AOM 17 by the anisotropic Bragg diffraction method. As a result, approximately 100% of light beams LA are directed to lens 64 as the 1st order dif-

fracted light beams $LA_1$.

On the other hand, light beam LB reflected by half mirror 62 is once again reflected by mirror 63 and directed to the second AOM 60, which is driven by high frequency signal $SF_2$ of frequency $f_2$. Then, light beams LB are diffracted by AOM 60 and approximately 100% become the first order diffracted light beams to be directed to lens 64. At this time, first diffracted light beams LA, and LB, are frequency modulated at $f_1$ and $f_2$, respectively, and are both polarized into the direction perpendicular to the page on which FIG. 16 is drawn. The first diffracted light beams $LA_1$ and $LB_1$, are directed to lens 64 and fall onto diffraction grating marks by intersecting each other at a given angle, thus they become a heterodyne beam of frequency $(f_1 - f_2)$. Alignment of the diffraction grating marks are detected by the phase difference between the heterodyne beams.

In the mode of embodiment shown in FIG. 16, AOM 17 and 60, which cause the anisotropic Bragg diffraction, are electrically connected in parallel. Therefore, the diffraction efficiency of light beams $LA_1$, $LB_1$ is maximized at both AOM 17 and 60, thus highly efficient heterodyne beams which are diffracted with low energy consumption can be obtained.

If the projection optical system 3 is not corrected for chromatic aberration with respect to alignment beams, the objective lens 38 should preferably be constructed with the double-focal-point optical system that was proposed in Japanese Patent Laid-Open No. 63-283129. This ensures that any double light beams that fall incident upon the double-focal-point optical system are split into mutually orthogonal polarized beams. One set of polarized beams that is directed to the first focal point condense on the reticle 1 while the other set of polarized beams that is directed to the second focal point condense on the wafer 4.

With references to FIG. 1(B), the spatial filters 32 and 35 are disposed at positions that are virtually conjugate with the pupil of the alignment optical system, i.e., at positions that are virtually conjugate with the pupil (the emission pupil) of the projection optical system 3. The filters are set so that they block any 0-order diffracted beams (regular-reflection beams) from the diffraction grating marks RM and WM that are formed on the reticle 1 and the wafer 4, and so that they admit the passage only of ±1st order diffracted beams (the diffracted beams that are generated upward and vertically with respect to the diffraction grating marks for the reticle 1 and the wafer 4. Similarly, the photoelectric detectors 36 and 32 are disposed with respect to the objective lenses 38 and 29 so that the detectors are approximately conjugate with the reticle 1 and the wafer 4, respectively.

In this case, most of the light beams $L_1$ (1) that fall incident upon the diffraction grating marks RM and WM are subjected by the AOM 17 to a frequency modulation of $(f_0 + f_3)$. Similarly, most of the light beams $L_2$ (-1) are subjected by the AOM 17 to a frequency modulation of $(f_0 - f_3)$. Consequently, the beat frequency of most of the interference beams composed of ±1st order diffracted beams from the diffraction grating marks RM and WM have a frequency $2f_3$, i.e., $(f_1 - f_2)$. It should be noted that the interference beams composed of ±1st order diffracted beams from the diffraction grating marks RM and WM also contain noise components that have other beat frequencies.

As a result, all of the three signals that are obtained from the photoelectric detectors 25, 33, and 36 for the alignment optical system of this example through the respective low-pass filter circuits 53a, 53b, and 53c contain sine wave optical beat signals of the same frequency $\Delta f = 2f_3 = f_1 - f_2$. The optical beat signal extraction unit (the Fourier transform circuit) in the phase detection system 50 extracts with high precision sine-wave optical beat signals with a frequency $\Delta f$ from the three photoelectric signals. If the optical beat signals corresponding to the reference diffraction grating 24, the diffraction grating mark RM, and the diffraction grating mark WM are designated as a reference beat signal, reticle beat signal, and wafer beat signal, respectively, the phase detection system 50 determines the phase difference $\Delta\theta RW$ between the reticle beat signal and the wafer beat signal, and supplies the phase difference $\Delta\theta RW$ to the main control system 51 that performs overall control on the operation of the entire apparatus.

Suppose that the reticle 1 and the wafer 4 are stopped at arbitrary positions without having been aligned. Then, the phase difference $\Delta\theta RW$ deviates from the original value by a predetermined phase. In this case, the phase difference (±180°) between the optical beat signals from the reticle 1 and the wafer 4 is uniquely associated with the amount of relative positional deviation less than or equal to 1/2 of the grating pitch of the diffraction grating marks that are formed on the reticle 1 and the wafer 4, respectively.

Therefore, by search alignment, the reticle 1 and the wafer 4 are aligned in the direction of the grating array so that the amount of their relative positional deviation is less than or equal to 1/2 of the grating pitch of the diffraction grating marks RM and WM. In this condition, the main control system 51 aligns the reticle and the wafer by two-dimensionally moving either the reticle stage 2 or the wafer stage 5 so that the phase difference $\Delta\theta RW$ obtained from the phase detection system 50 by a servo system 52 will be either 0 or a predetermined reference value. A high-precision alignment can be effected in this manner.

It should be noted that alignment can also be performed by using the reference beat signal obtained from the photoelectric detector 25 as a fiducial signal, so that the phase difference obtained between the fiducial signal and the reticle beat signal, and between the fiducial signal and the wafer beat signal will be either 0 or a predetermined reference value. The drive signal (high-frequency signals $SF_1$ and $SF_2$) that drive the AOM 17 can also be used as fiducial signals. In this case, signals that are obtained by mixing the high-frequency signals $SF_1$ and $SF_2$ can be used as substitutes for the reference beat signals so that the optical system of FIG.1(B) that includes the lens 23 and the reference diffraction grating 24 can be eliminated. The result is a substantially simplified alignment optical system.

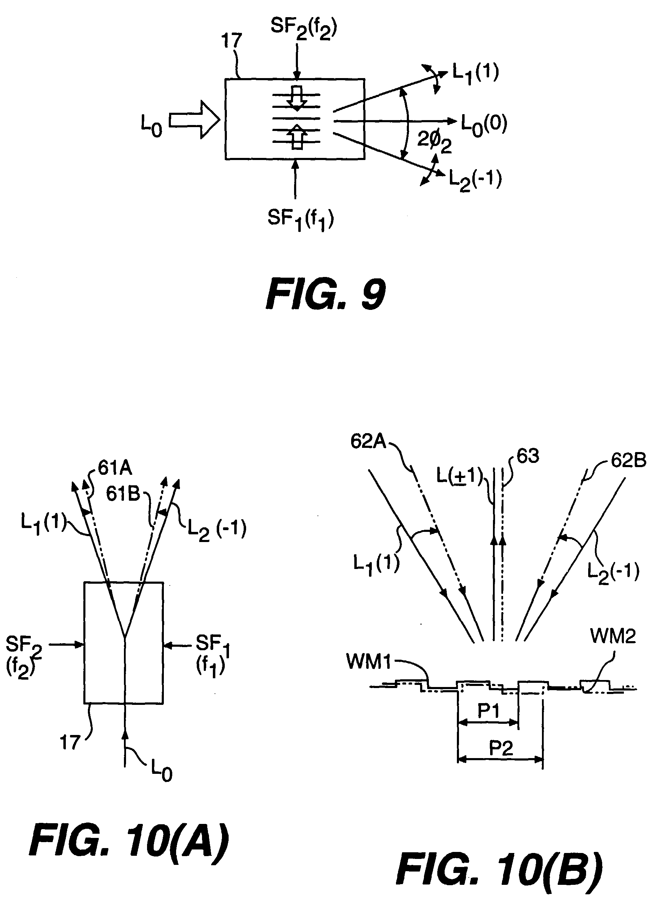

The following is an explanation of the components of the present example that generates two light beams having frequencies different from each other, in terms of its structure and operating principles with reference to FIG. 9.

As shown in FIG. 9, when virtually white light beams $L_0$ fall vertically upon the AOM 17, the Raman-Nath diffraction of the AOM 17 generates diffracted beams of different orders for different wavelengths. In this case the following approximate relationship holds if it is assumed that the difference frequency $(f_1 - f_2)$ is small when compared with the frequencies $f_1$ and $f_2$, and if $\phi_2$ denotes the diffraction angle of diffracted beams relative to the normal direction of the AOM 17; $\Lambda_G$ denotes the wavelength (pitch) of the progressive waves inside the AOM 17; V denotes the velocity (the velocity of sound) of the progressive waves; and $\lambda$ denotes the central wavelength of light. It is also assumed that the order of the diffracted beams is 1.

$$\Lambda_G = V / f, \ (f = (f1 + f2) / 2) \qquad (9)$$

$$\sin \phi_2 = \lambda / \Lambda_G \qquad (10)$$

Consequently, by varying the frequencies $f_1$ and $f_2$, according to Equation (9) it is possible to vary the wavelength $\Lambda_G$ of progressive waves. As a result, according to Equation (10), the diffraction angle $f_2$ of the $\pm$1st order diffracted beams from the AOM 17 changes. In this example, the regions in the AOM 17 upon which ultrasonic waves act are virtually conjugate with the diffraction grating mark RM on the reticle 1 and the diffraction grating mark WM on the wafer 4, respectively. Therefore, by varying the frequencies $f_1$ and $f_2$ and by varying the diffraction angle $f_2$ of the light beams $L_1$ (1) and $L_2$ (-1) consisting of $\pm$1st order diffracted beams from the AOM 17, it is possible to adjust the angle of intersection of the light beams $L_1$ (1) and $L_2$ (-1) that are directed onto the diffraction grating marks RM and WM, and hence the pitch of any interference fringes that are formed on those marks.

Suppose, for example, the velocity of sound in the acoustico-optical medium inside the AOM 17 is 3000 m/s, the frequency $f_1$ of the high-frequency signal $SF_1$ that is applied to the AOM 17 is 50.1 MHz, and the frequency $f_2$ of the high-frequency signal $SF_2$ that is applied to the AOM 17 is 50 MHz. In this case, the beat frequency Df will be 100 kHz. Then, according to Equation (9), the wavelength (pitch) $\Lambda_G$ of the progressive waves that occur in the acoustico-optical medium for the AOM 17 will be 60 mm. If the pitch $P_{WM}$ of the diffraction grating mark WM on the wafer 4, shown in FIG. 1, is 4 mm, the reduction factor for a system composed of the relay optical system located between the AOM 17 and the reticle 1 and composed of the projection optical system 3 needs to be only 1/15.

Sometimes a magnification factor error arises, for example, in the intervening relay optical system, due to adjustment errors and other reasons. In such a case, if the magnification factor error is 1% and the frequencies $f_1$ and $f_2$ remain the same, the pitch of the interference fringes due to the light beams $L_1$ (1) and $L_2$ (-1) that are directed onto the diffraction grating mark WM through the relay optical system and the projection optical system 3 increases by 1%. This prevents the $\pm$1st order diffracted beams from the diffraction grating mark WM from being generated vertically upward and in parallel.

To avoid this problem, each of the frequencies $f_1$ and $f_2$ of the high-frequency signals that are applied to the AOM 17 should be increased by approximately 1% while holding the difference frequency $(f_1 - f_2)$ constant. In the present example, it suffices to increase each of the frequencies $f_1$ and $f_2$ by 500 kHz so that the frequency $f_1$ is 50.6 MHz and the frequency $f_2$, 50.5 MHz. In this way, it is possible to reduce by 1% the pitch of the interference fringes that are formed on the diffraction grating mark WM while holding the beat frequency $\Delta f$ unchanged at 100 kHz. This ensures that the position of the diffraction grating mark WM can be detected with a high degree of precision without requiring a change in the properties of the phase detection system 50 shown in FIG. 1(A).

The stability of the frequencies $f_1$ and $f_2$ of the high-frequency signals $SF_1$ and $SF_2$ supplied by the AOM drive system 60 to the AOM 17 as a rule can easily be achieved in the order of ppm. Therefore, the frequencies $f_1$ and $f_2$ for the high-frequency signals can be set with a high degree of precision. With regard to the frequency $f_1$, a 1% increase, to be exact, will amount to 50.601 MHz. However, in order to hold the beat frequency Df constant, the frequency of $f_1$ is set at 50.6 MHz. The resulting frequency error is 0.002%, which can be ignored. In order to optimize the frequencies $f_1$ and $f_2$, it suffices to set at a maximum the amplitude of the optical beat signals from the photoelectric detector 33 (or the low-pass filter 53b). Thus, in this example, any errors, originating from the optical system, in the pitch of alignment marks (diffraction grating marks RM and WM) and in the pitch of interference fringes that are created by the light beams used for measurement purposes can be matched easily and with a high-degree of precision.

Suppose that the diffraction grating mark WM on the wafer 4 in FIG. 1(A) is the diffraction grating mark WM1 with a pitch P1 (= 4 $\mu$m) indicated in FIG. 10(B). Also assume that, as shown in FIG. 10(A), directing the light beams $L_1$ (1) and $L_2$ (-1) generated from the AOM 17 along the optical path indicated by the solid line onto the diffraction grating mark WM1 generates $\pm$1st order diffracted beams ($\pm$) that propagate vertically upward from the diffraction grating mark WM1. Also, assume that when subsequently another layer on the wafer 4 is exposed, the diffraction grating mark on the wafer 4 is a diffraction grating mark WM2 with a pitch P2 equal to 6 μm, as shown in FIG. 10(B).

In light of the fact that the reduction factor from the AOM 17 to the diffraction grating mark WM2 is 1/15, to detect the position of the diffraction grating mark WM2 it suffices to set the wavelength (pitch) $\Lambda_G$ of the progressive waves that are generated in the acousto-optical medium for the AOM 17 to 90 μm. In order to accomplish this, it suffices to set the frequencies $f_1$ and $f_2$ of the high-frequency signals $SF_1$ and $SF_2$ that are applied to the AOM 17 to 2/3 (= 60/90) times the frequencies that are employed for detecting the position of the diffraction grating mark WM1, i.e., 33.433 (50.1 x 2/3) MHz and 33.333 (50 x 2/3) MHz. It should be noted that the 33.433 MHz rate for the frequency $f_1$ has been corrected in order to ensure that the beat frequency $\Delta f (= f_1 - f_2)$ is 100 kHz. In this case also, the conditions necessary for Equation (9) are essentially satisfied due to the fact that any error in the frequency $f_1$ is less than 0.1%.

As a result, the light paths for the light beams $L_1$ (1) and $L_2$ (-1) that are generated by the AOM 17 shift to the light paths 61A and 61B, which are indicated by the inner double-dot-chain lines. This is shown in FIG. 10(A). Similarly, the light path for the light beams $L_1$ (1) and $L_2$ (-1) that are directed onto the diffraction grating mark WM2 also shift to the light paths 62A and 62B, which are indicated by the inner double-dot-chain lines. Consequently, the ±1st order diffracted beams (±) indicated by the light path 63 are generated vertically and upward from the diffraction grating mark WM2. This is shown in FIG. 10(B). Therefore, by switching the frequencies $f_1$ and $f_2$ for the signals that drive the AOM 17 according to the pitch for the diffraction grating marks to be detected, the positions of diffraction grating marks of different pitches can be detected with a high degree of precision without requiring any modification of the intervening relay optical system.

If f denotes the frequency of the ultrasonic waves that are applied to the acousto-optical medium for an AOM, the Q parameter, defined by the following equation, must be chosen carefully and appropriately:

$$Q = (2 \pi L \lambda f^2) /nV^2 \qquad (11)$$

where L denotes the size of the area on which ultrasonic waves act, λ denotes the central wavelength of the luminous beam to be used, n denotes the refractive index of the acousto-optical medium, and V denotes the velocity of the ultrasonic waves.

Bragg diffraction occurs when the value of Q is approximately 4p. Raman-Nath diffraction occurs when the value of Q is approximately 2. The example of FIG. 9 requires the use of the Raman-Nath diffraction; therefore, the value of Q is chosen to be approximately 2. By adjusting the frequency f of the ultrasonic waves within the range in which the necessary condition for the value of Q is essentially satisfied, the pitch of the progressive waves in the acousto-optical medium can be made to vary to some extent.

Returning to FIG. 1(A), in this example a luminous beam (white light) having a predetermined wavelength region is used as light beams $L_1$ (1) and $L_2$ (-1). As indicated by Equation (10), for each luminous beam of a specific wavelength, the diffraction angle $f_2$ from the AOM 17 changes so that the ±1st order diffracted beams from the diffraction grating marks RM and WM are each emitted vertically upward. Therefore, the interference beat light with a predetermined wavelength region (which can be regarded as multi-wavelength light rays) having a predetermined beat frequency Df can be photoelectrically detected by means of the photoelectric detectors 33 and 36. Thus, at each wavelength, the beat light rays containing positional information about diffraction grating marks can be detected. As a result, the averaging effect of beat light beams of various wavelengths reduces the influence of the asymmetry of the diffraction grating marks WM on the wafer 4. It also minimizes the influence of the thin-film interference on the photoresist layer (the influence of variation in light dose). In this manner, high-precision alignment based upon the heterodyne interference method can be achieved.

Furthermore, the luminous beams, which have a predetermined wavelength region (multi-wavelength light beams) and which have been symmetrically divided with respect to the incident direction (the direction of the optical axis) by the AOM 17 advances through the relay optical system symmetrically and in parallel. Therefore, in principle no light path length difference arises between the split light beams. Consequently, the wave fronts between the split light beams are in phase with a phase difference of 0. This not only permits high-precision alignment, but it also allows for the construction of a compact apparatus that can easily be adjusted.

The following is a description of the specific structure of the AOM 17 used in this example, with reference to FIG. 11.

FIG. 11 shows the AOM 17 that is used in FIG. 1(A) and FIG. 1(B). In FIG. 11, an electrode plate 42A, a transducer 43A that generates ultrasonic waves, an electrode plate 44A, and a sound absorber 46B are secured in sequence to one side of acousto-optical medium 41A. High-frequency signals (drive signals) with a frequency $f_1$ are supplied by the AOM drive system 60 to the space between the electrode plates 42A and 44A, thus generating progressive waves 47A. Similarly, an electrode plate 42B, a transducer 43B that generates ultrasonic waves, an electrode plate 44B, and a sound absorber 46A are secured in sequence to the other side of the acousto-optical medium 41A. High-frequency signals with a frequency $f_2$ are supplied by the AOM drive system 60 to the space between the electrode plates 42B and 44B, thus generating progressive waves 47B. The sound absorbers 46A and 46B perform the function of absorbing the ultrasonic waves (progressive waves) that are generated by the oppositely disposed transducers 43A and 43B and of preventing the generation of any reflected waves.

In this case, monocrystalline tellurium dioxide (TeO$_2$), quartz crystal, quartz, and monocrystalline lead molybdate can be used in addition to ordinary glass for an acousto-optical medium 41A. For sound absorbers 46A and 46B, materials with an acoustic impedance that is close to that of the acousto-optical medium 41A and with a propensity to absorb sound waves can be used. The term acoustic impedance refers to the product of the density of an object and the speed of sound. Specifically, metal films of lead or aluminum can be used as sound absorbers 46A and 46B. Monocrystalline lithium niobate (LiNbO$_3$), monocrystalline LiIO$_3$, and monocrystalline Ba$_2$NaNb$_5$O$_{15}$ can be used as transducers 43A and 43B.

The area situated between the transducers 43A and 43B comprises an ultrasonic wave-acting region 48A, which has a width D1. Progressive waves with a frequency essentially equal to f$_3$ (= (f$_1$ - f$_2$)/2) are formed in the ultrasonic wave-acting region 48A. Therefore, the luminous beams L$_0$ are actually diffracted by the progressive waves of frequency f$_3$ and become +1st order diffracted beams (luminous beams) L$_1$(1) and -1st order diffracted beams (luminous beams) L$_2$(-1).

Conceptually, this phenomenon can be thought of as the formation of mixed waves of +1st order diffracted beam L$_{0A}$(1) due to the progressive wave 47A of the luminous beam L$_{0A}$ in the luminous beams L$_0$, and +1st order diffracted beams L$_{0B}$(1) due to the progressive wave 47B of the luminous beam L$_{0B}$. Similarly, the phenomenon can be thought of as the formation of mixed waves of -+1st order diffracted beams L$_{0A}$(1) due to the progressive wave 47A of the luminous beam L$_{0A}$ in the luminous beams L$_{0A}$, and - 1st order diffracted beams L$_{0B}$(1) due to the progressive wave 47B of the luminous beams L$_{0B}$. The change in the frequency of the luminous beams L$_1$(1) is f$_3$, and the change in the frequency of the luminous beams L$_2$ is -f$_3$. Furthermore, any zeroth order beams L$_0$(0) of the luminous beams L$_0$ can completely be removed by means of the spatial filter 19 in FIG. 1(B).

The following describes a variation of the AOM 17 in FIG. 11 with reference to FIG. 12. This variation divides incident luminous beams L$_0$ into two light beams L$_1$(1) and L$_2$(-1) by using two AOMs instead of one AOM 17.

FIG. 12 shows two AOMs 17A and 17B that can be used instead of a single AOM 17. In the first AOM 17A in FIG. 12, an electrode plate 42A, a transducer 43A that generates ultrasonic waves, and an electrode plate 44A are secured in sequence to one side of an acousto-optical medium 41A. A sound absorber 46A is secured to the other side. The AOM drive system 60 supplies high-frequency signals with a variable frequency f$_1$ to the space between the electrode plates 42A and 44A, thus forming progressive waves 47A.

In the second AOM 17B, an electrode plate 42B, a transducer 43B that generates ultrasonic waves, and an electrode plate 44B are secured in sequence to the other side an acousto-optical medium 41B. A sound absorber 46B is secured to the other side. The AOM drive system 60 supplies high-frequency signals with a variable frequency f$_2$ to the space between the electrode plates 42B and 44B, thus forming progressive waves 47B that propagate in the direction opposite to that of the progressive waves 47A in the first AOM 17A.

The area situated between the transducers 43A and 46A comprises a first ultrasonic wave-acting region. Similarly, the area situated between the transducers 43B and 46B comprises a second ultrasonic wave-acting region. With reference to incident luminous beams L$_0$, mixed waves of +1st order diffracted beams L$_0$(1) due to the progressive wave 47A in the AOM 17A and +1st order diffracted beams L$_A$(1) due to the progressive wave 47B in the AOM 17B become the luminous beams L$_1$(1).

Mixed waves of -1st order diffracted beams L$_0$(-1) due to the progressive wave 47A and -1st order diffracted beams L$_A$(-1) due to the progressive wave 47B become the luminous beams L$_2$(-1). The change in the frequency of the luminous beams L$_1$(1) is essentially (f$_1$ - f$_2$)/2, and the change in the frequency of the luminous beams L$_2$ is essentially -(f$_1$ - f$_2$)/2. Further, the gap S, which is equivalent to the length of the air space between the center of the ultrasonic wave-acting region in the AOM 17A and the center of the ultrasonic wave-acting region in the AOM 17B is set so as to maximize the contrast for the photoelectric conversion signals (light beat signals) of the interference beams for the two light beams L$_1$ (1) and L$_2$(-1).

In the variation in FIG. 12, as in preceding cases, by varying the frequencies f$_1$ and f$_2$ of the high-frequency signals that are supplied by the AOM drive system 60 to the AOMs 17A and 17B, it is possible to address magnification factor errors in the relay optical system and to detect diffraction grating marks RM and WM of various pitches.

If at all possible, the gap between the AOMs 17A and 17B should be 0. However, if the AOMs are placed adjacent to each other, as in FIG. 12, the gap S cannot be reduced to 0. Therefore, to make the gap s essentially 0, it suffices to provide a relay lens system between the two AOMs.

FIG. 13 shows a variation in which a relay lens system is provided as mentioned above. In FIG. 13, a relay lens system comprising two lenses 54A and 54B is provided between the first AOM 17A and the second AOM 17B. The first AOM 17A in FIG. 13 is constructed by turning the first AOM 17A in FIG. 12 upside down, with the direction of progressive waves reversed. In this relay lens system, the focal distances for the lenses 54A and 54B are set to $FD_1$ and $FD_2$, center P of the ultrasonic wave-acting region for the AOM 17A is positioned at the near-side focal point, the distance between the two lenses 54A and 54B is set to $FD_1 + FD_2$, and center Q of the ultrasonic wave-acting region for the AOM 17B is positioned at the far-side focal point of the lens 54B. In this relay lens system, center P of the ultrasonic wave-acting region for the AOM 17A and center Q of the ultrasonic wave-acting region for the AOM 17B are conjugate. In this case, a relay lens system comprising lenses 54A and 54B should preferably be telecentric on both sides. In each relay operation, the progressive waves in the two AOMs 17A and 17B are designed to propagate in the same direction.

In this variation, the -1st order diffracted beams $L_0(-1)$, the +1st order diffracted beams $L_A(1)$, and the zeroth order beams $L_A$ cross one another at center Q of the AOM 17B through the relay lens system. Consequently, the +1st order diffracted beams $L_A(1)$ and the +1st order diffracted beams $L_0(1)$ from the AOM 17B, due to the zeroth order beams $L_A$, are emitted from center Q essentially in a completely superimposed manner. Similarly, the -1st order diffracted beams $L_A(-1)$ and the -1st order diffracted beams $L_0(-1)$ from the AOM 17B, due to the zeroth order beams $L_A$, are emitted essentially in a completely superimposed manner. This increases the utilization efficiency of alignment light beams and enhances the contrast of the light beat signals that are obtained.

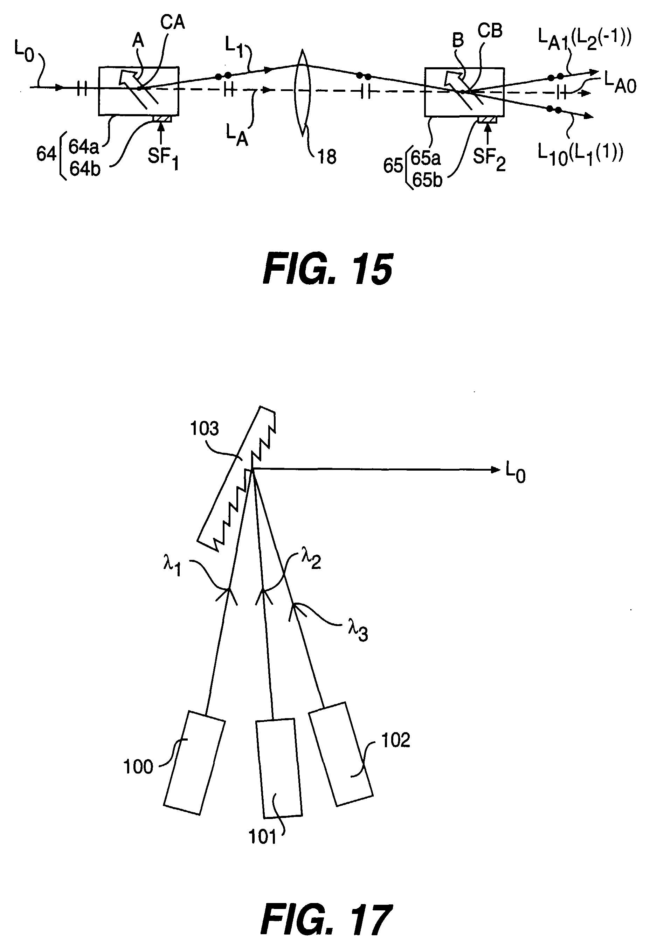

The following is an explanation of the second mode of the embodiment of the present invention with reference to FIG. 14 and FIG. 15.

This example also uses the projection exposure apparatus shown in FIG, 1(B). However, this example differs from the preceding examples in that it uses an anisotropic Bragg diffraction acousto-optical modulator as a means of generating double light beams in a heterodyne interference alignment sensor. The following describes the two-luminous-beam generation means that is employed in this example.

FIG. 14 shows the two-luminous-beam generation means used in the alignment sensor in this example. In FIG. 14, two acousto-optical modulators (AOMs) 64 and 65 are provided along the light path for the incident luminous beams $L_0$ with a predetermined hand width. The first AOM 64 is made by attaching a transducer 64b, such as a piezoelectric device, to an acousto-optical medium 64a made of tellurium dioxide ($TeO_2$), quartz, or lead molybdate ($PbMoO_4$) (the electrodes and the sound absorber are omitted). The AOM drive system 60 in FIG. 1(B) applies high-frequency signals $SF_1$ with a frequency $f_1$ to the transducer 64b (actually the electrodes that sandwiches the transducer between them). Similarly, the AOM 65 is also made by attaching a transducer 65b to an acousto-optical medium 65a. The AOM drive system 60 applies high-frequency signals $SF_2$ with a frequency $f_2$ to the transducer 65b. It should be noted that the transducer 65b is attached to the opposite side from the transducer 64b.

In this case, the direction in which the incident luminous beams $L_0$ propagate is designated as the z-direction, and the direction orthogonal to the z-direction on the plane of the paper on which FIG. 14 is drawn is designated as the x-direction. Then, the transducer 64b supplies transversal ultrasonic propagation waves A in a direction that crosses the z-axis at a predetermined angle on the x,z-plane (the plane parallel to the paper on which FIG. 14 is drawn), in the acousto-optical medium 64a. The ultrasonic propagation waves A cause some of the luminous beams $L_0$ to be subjected to anisotropic Bragg diffraction. Similarly, the transducer 65b supplies transversal ultrasonic propagation waves B in a direction, symmetric with the ultrasonic propagation waves A, that cross the z-axis on the x,z-plane in the acousto-optical medium 65a. The ultrasonic propagation waves B cause some of the luminous beam from the AOM 64 to be subjected to anisotropic Bragg diffraction.

In the anisotropic Bragg diffraction in this example, only the luminous beams that have been polarized in the direction of propagation of the ultrasonic propagation waves A (or B) and in a direction parallel to the plane (the x,z-plane) that includes the incident direction of the incident luminous beams are subjected to 1st order Bragg diffraction. The polarization state of the zeroth order beams remains unchanged, and the direction of polarization of the 1st order diffracted beams rotates in a direction that is orthogonal to the incident angle. Although the zeroth order beams are not subjected to a frequency modulation, the 1st order diffracted beams receive a frequency modulation of $f_1$ (or $f_2$). Therefore, in FIG. 14, the incident luminous beams $L_0$ are polarized in the x-direction in advance. This ensures that the zeroth order beams $L_A$ due to the AOM 64 of the luminous beams $L_0$ directly advances to the AOM 65.

The 1st order diffracted beams $L_1$ due to the AOM 64 of the luminous beams $L_0$ are subjected to a modulation with a frequency $f_1$. The direction of polarization of these beams assumes a direction perpendicular to the paper on which FIG. 14 is drawn, and moves toward the AOM 65. In this case, in the first AOM 64, the strength of the ultrasonic propagation waves A is adjusted so that the zeroth order beam $L_A$ and the 1st order diffracted beams $L_1$ will have an essentially equal strength. This ensures that all beams other than zeroth order beams and 1st order diffracted beams become significantly attenuated.

In contrast, in the second AOM 65, the strength of the ultrasonic propagation waves B is adjusted so that the light beams that fall incident in the +z direction and parallel to the x,z-plane will be diffracted as an essentially 100% 1st order diffracted beams. In the second AOM 65, the 1st order diffracted beams $L_1$ from the first AOM 64 have an angle that makes the diffracted beam relatively immune to Bragg diffraction even at the incident angle. Therefore, virtually 100% of the zeroth order beam $L_A$ is diffracted by the AOM 65 and becomes 1st order diffracted beams $L_{A1}$ that have been subjected to a modulation with a frequency $f_2$. The 1st order diffracted beams $L_1$ pass through the AOM 65 virtually unaffected and becomes zeroth order beams $L_{I0}$. The 1st order diffracted beams $L_{A1}$, due to the diffraction that they underwent at the AOM 65, have a polarization direction that has rotated in a direction perpendicular to the paper on which FIG. 14 is drawn. This is also true of the polarization direction of the zeroth order beams $L_{I0}$. Therefore, the interference between the 1st order diffracted beams $L_{A1}$ and the zeroth order beams $L_{I0}$ produces heterodyne beams with a frequency $(f_1 - f_2)$. Although a small amount of zeroth order beams $L_{A0}$ due to the AOM 65 of the zeroth order beams $L_{A0}$ is sometimes generated, the zeroth order beam $L_{A0}$ can be shielded by means of a spatial filter similar to the spatial filter shown in FIG. 1(B).

In this example, the 1st order diffracted beams $L_{A1}$ and the zeroth order beams $L_{I0}$ are used, respectively, instead of the light beams $L_2$ (-1) and $L_1$(1) shown in FIG. 1(B). In this manner, the positions of the diffraction grating marks RM and WM are detected. In this case, almost 50% of the luminous beams $L_0$ falling incident upon the AOMs 64 and 65 becomes luminous beams $L_{I0}$ that have been subjected to a frequency modulation with a frequency $f_1$. Almost all of the remainder becomes luminous beams $L_{A1}$ that have been subjected to a frequency modulation with a frequency $f_2$. This substantially increases the diffraction efficiency. Further, in this example, by varying the frequencies $f_1$ and $f_2$ of the high-frequency signals that are supplied by the AOM drive system 60 in FIG. 11 to the AOMs 64 and 65, magnification factor errors in the relay optical system can be dealt with, and diffraction grating marks RM and WM of various pitches can be detected. Because anisotropic Bragg diffraction is used, the range of variation (the range of variation for frequencies $f_1$ and $f_2$) of the diffraction angle of the diffracted beams from the AOMs 64 and 65 can be doubled when compared with the case in which Raman-Nath diffraction is used as in FIG. 9. Therefore, this example offers the advantage that the range of pitches for the diffraction grating marks RM and WM that can be detected can be almost doubled when compared with the case in which the AOM 17 in FIG. 9 is used.

The following is an attempt to estimate the power consumption that results when crystals of tellurium dioxide are used to make the acousto-optical medium 64a and 65a in FIG. 14. If the pitch of the diffraction grating mark WM as an alignment marker on the wafer 4 is 8 μm, the size of the diffraction grating mark WM is 100 μm square, the frequencies $f_1$ and $f_2$ of the ultrasonic waves that are applied to the AOMs 64 and 65 are approximately 40 MHz, and the speed of sound is 640 m/s, the size of the ultrasonic wave-acting region will be approximately 200 μm square. In this case, the ultrasonic wave power that is applied to the acousto-optical medium for the AOMs 64 and 65 is less than approximately 10 mW, respectively. Therefore, two media require a maximum total power of approximately 20 mW.

In contrast, a design in which two acousto-optical modulators employing isotropic Bragg diffraction are connected in series requires a total ultrasonic wave power of 2 to 3 W. Thus, by using acousto-optical modulators employing anisotropic Bragg diffraction, as in the present example, the power consumption by acousto-optical modulators can be reduced by a factor of 100. This reduces the extent of the heat deformation that occurs in the alignment optical system and improves the precision of position detection. Also, because the heat dissipation from the AOMs 64 and 65 is significantly reduced, the frequency modulation of the luminous beams $L_0$ can be performed stably and continuously.

Further, because it positions two AOMs 64 and 65 close to each other, the present example can simplify and reduce the size of the two-luminous-beam generation means. However, as shown in FIG. 14, in a structure in which two AOMs 64 and 65 are provided close to each other, center CA of the ultrasonic wave-acting region for the AOM 64 and center CB of the ultrasonic wave-acting region for the AOM 65 are shifted in the direction of the optical axis. Therefore, if the light beams $L_{A1}$ and $L_{I0}$ are a broad-band area (or multiple wavelengths), the intersection of the two light beams deviates in a direction perpendicular to the optical axis for each partial wavelength region (or the wavelength). To address this problem, it suffices to pick up the interference beams from diffraction grating marks by using different photoelectric detectors for different, predetermined wavelength regions (or for each wavelength). Additionally, a dispersion unit, such as a direct-view prism, can be used to correct for wavelength-induced deviations in the intersection between the two light beams.

In the embodiment shown in FIG. 14, in order to make essentially 0 the gap between the ultrasonic wave-acting regions CA and CB for the two AOMs 64 and 65, a relay optical system may be provided between the two AOMs 64 and 65.

FIG. 15 shows a variation example in which a relay optical system is provided between two AOMs that perform anisotropic Bragg diffraction. In FIG. 15, center CA (diffraction point) of the ultrasonic wave-acting region in the acousto-optical medium 64a for the AOM 64 and center CB (diffraction point) of the ultrasonic wave-acting region in the acousto-optical medium 65a for the AOM 65 are conjugate with respect to the relay optical system 18. Therefore, the direction in which the high-frequency signal $SF_2$ is applied in the AOM 65 is reversed from the direction shown in FIG. 9.

The luminous beams $L_0$ polarize in a direction parallel to the paper on which FIG. 15 is drawn, and fall incident upon the AOM 64. The 1st order diffracted beams $L_1$ and the zeroth order beams $L_A$ fall incident upon the AOM 65 through the relay optical system 18, in such a way that they cross each other at the center CB of the ultrasonic wave-acting region in the acousto-optical medium 65a for the AOM 65. Virtually 100% of the zeroth order beams $L_A$ is diffracted by the ultrasonic propagation waves B of the AOM 65 and becomes 1st order diffracted beams $L_{A1}$ that have been subjected to a frequency modulation with a frequency $f_2$. The 1st order diffracted beams $L_1$ pass through the AOM 65 virtually intact and become a zeroth order beams $L_{I0}$. Therefore, both 1st order diffracted beams $L_{A1}$ and zeroth order beams $L_{I0}$ can be used as position detection light beams.

In this variation example also, the use of anisotropic Bragg diffraction significantly increases the diffraction efficiency. In this variation example, the relay optical system 18 makes conjugate the centers CA and CB of the ultrasonic wave-acting regions inside the AOMs 64 and 65. Due to this fact, the broadband light beams $L_{I0}$ and $L_{A1}$, after being emitted by the AOM 65, have an enhanced symmetry when compared with the embodiment mode shown in FIG. 14. Therefore, even when broad-band light beams are used, the contrast of light beat signals does not decline. This permits high-precision position detection by minimizing the influence of photoresist thin-film interferences and step differences in diffraction grating marks WM.

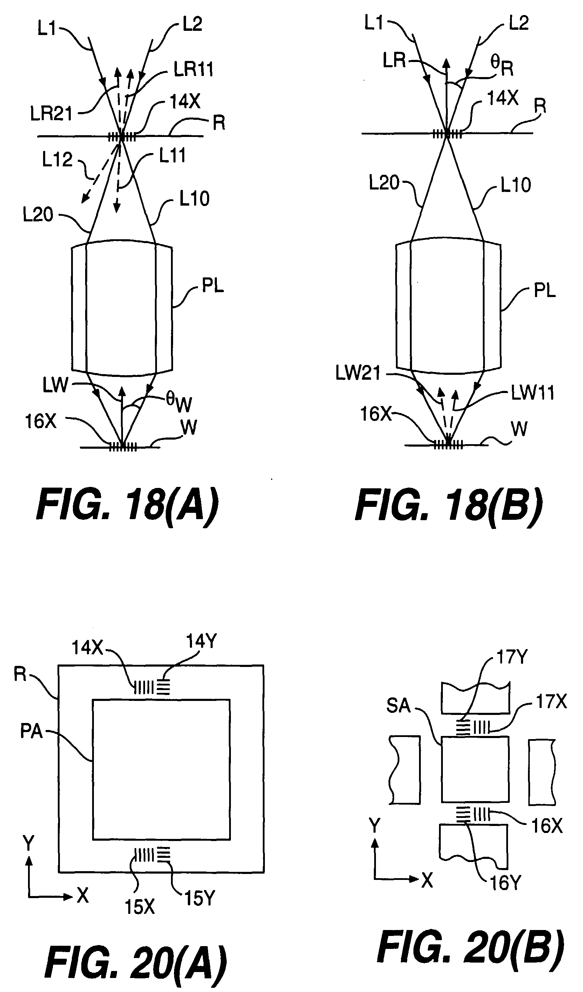

The first and second embodiment modes described above use a white light source 10, including a xenon lamp or a halogen lamp, as well as a variable stop 11 and a condenser lens 12, as light-source means. The luminous beams $L_0$ (multi-wavelength beams), which are essentially white, emitted by the light-source means, are made incident upon the AOM 17 and other components. As shown in FIG. 17, however, light beams from laser sources 100, 101, and 102 that emit monochrome beams of different frequencies $I_1$, $I_2$, and $I_3$ can be directed onto a diffraction grating 103 with a serrated cross section at different incident angles, and a light source system that emits luminous beams $L_0$ that can be obtained by composing the beams of different wavelengths from the laser sources 100, 101, and 102 can be used as a light-source means. Further, laser beams of different wavelengths can be composed into coaxial beams by means of a dichroic mirror system, and the resulting beams can be used.

The position detecting method of the present invention is a position detecting method which, before copying a pattern formed on a mask onto a photosensitive substrate with illuminating light for exposure, uses position detection light of a predetermined wavelength to detect positional deviation between a grating-shaped alignment mark on the mask and a grating-shaped alignment mark on the photosensitive substrate, characterized in that it sets the pitch of the alignment mark on the mask and the pitch of the alignment mark on the photosensitive substrate so that the diffracted light from these two alignment marks due to position detection light is not superimposed, and it detects the positional deviation of these two alignment marks based on the phase of diffracted light from these two alignment marks obtained when these two alignment marks are simultaneously irradiated with position detection light.

In such an invention, as shown in FIGs. 18(A) and 18(B) for example, when positioning the projection exposure apparatus which copies the pattern on the mask (R) onto the photosensitive substrate (W) via the projection optical system (PL), the position of the two alignment marks (14X and 16X) is detected using position detection light (L1, L2) following light paths, which are close to the same axis (along the same optical axis). In other words, to use the two-beam interference method, if the intersection angle of position detection light (L1, L2) is first set to match the pitch of alignment mark (16X) on photosensitive substrate (W) as shown in FIG. 18(A), interference light (LW) is created which is composed of ±1-order diffracted light from the alignment mark (16X), for example, but the direction of diffracted light from alignment mark (14X) on mask (R) is different from the direction of interference light (LW), so only this interference light (LW) is detected.

As shown in FIG. 18(B), if the intersection angle of position detection light (L1, L2) is set to match the pitch of alignment mark (14X) on mask (R), interference light (LR) is created which is composed of ±1-order diffracted light from the alignment mark (14X), for example, but the direction of diffracted light from alignment mark (16X) is different from the direction of interference light (LR), so only this interference light (LR) is detected. Therefore the positions of the two alignment marks (14X and 16X) can each be accurately detected using the phase of these interference lights (LW and LR), and the positional deviation can be accurately detected based on position detection light from these two marks using the difference in detection results.

In this case irradiation of the two marks with position detection light can be performed by a shared optical system, so the optical system is simplified. Furthermore, by first finding the projection magnification based on position detection light (alignment light) and the projection magnification based on illumination light for exposure (exposure light) and converting this detection result into positional deviation based on illumination light for exposure, it is possible to accurately detect positional deviation based on illumination light for exposure.

In this case, when the pattern on mask (R) is copied to the photosensitive substrate via the projection optical system (PL), if the pitch of alignment mark (14X) on mask (R) is Pr and the pitch of alignment mark (16X) on the photosensitive substrate (W) is Pw and the projection optical system (PL)'s projection magnification from mask (R) to photosensitive substrate (W) based on position detection light is β, pitch Pr and Pw should be set so that the following two relationships are established, using optional integers m and n which are equal to or greater than 1.

$$Pw \neq m \cdot \beta \cdot Pr \qquad (12)$$

$$n \times Pw \neq \beta \cdot Pr \qquad (13)$$

To be more specific, the pitch Pw should be set to a value that is a few percent different from the value established by $m \cdot \beta \cdot Pr$ or by $\beta \cdot Pr/n$. In this way the 0-order light and 1-order and higher diffracted light from the light beam incident upon the alignment mark (14X) on mask (R) will not combine with and advance in the same direction in the diffracted light obtained by irradiating the alignment mark (16X) on the photosensitive substrate (W). On the other hand, 0-order light and 1-order and higher diffracted light from the light beam incident upon the alignment mark (16X) on the photosensitive substrate (W) will not have diffracted light advancing in the same direction even if diffracted by the alignment mark (14X) on mask (R). In other words, the diffracted light from the two alignment marks is not mutually intermixed.

Equation (12) and Equation (13) above apply when detecting an alignment mark (14X) on a mask (R) and an alignment mark (16X) on a photosensitive substrate (W) in a projection exposure apparatus which copies a pattern on mask (R) onto a photosensitive substrate (W) via a projection optical system (PL). But they can also be used in a proximity type exposure apparatus which brings the pattern on a mask (R) near to or in intimate contact with a photosensitive substrate (W) and exposes it without using a projection optical system (PL). There is no projection optical system (PL) in this sort of proximity type exposure apparatus, but mask (R) and photosensitive substrate (W) are arranged close to one another, so Equation (12) and Equation (13) can be handled by making the projection optical system (PL)'s projection magnification $\beta$ equal to 1. Therefore, unnecessary diffracted light from two alignment marks is not intermixed and only the required diffracted light is obtained in a proximity type exposure apparatus too.

Therefore even if the 0-order light in the light beam irradiating the alignment mark (14X) irradiates as-is the alignment mark (16X), the other diffracted light from the alignment mark (14X) will not become noise light in the diffracted light from the alignment mark (16X), and the opposite is also true, so the position detection light for these two marks can be irradiated along the same axis.

When doing so, time sharing should be used to detect the phase of diffracted light from alignment mark (14X) on mask (R) and the phase of diffracted light from alignment mark (16X) on photosensitive substrate (W) due to position detection light. Using time sharing the position of two alignment marks (14X and 16X) can be detected in sequence via a shared receiving optical system.

Additionally, the positional deviation of these two alignment marks should be found by comparing the phase of the diffracted light from these two alignment marks (14X and 16X) due to position detection light with the phase of a predetermined reference signal. When detecting position with the two-beam interference method and the heterodyne interference method, the reference signal can be generated by mixing the drive signal of an acousto-optical device in order to generate two light beams with different frequencies, for example. Then, based on the discrepancy in projection magnification for position detection light and illumination light for exposure, the positional deviation thus obtained for alignment mark (16X) on photosensitive substrate (W) can be converted into positional deviation based on illumination light for exposure, so positional deviation can be accurately found based on illumination light for exposure.

The position detecting apparatus of the present invention is a position detecting apparatus which, before copying a pattern formed on a mask (R) onto a photosensitive substrate (W) with illuminating light for exposure (IL), uses position detection light (L) of a predetermined wavelength to detect positional deviation between a grating-shaped alignment mark (14X) on the mask (R) and a grating-shaped alignment mark (16X) on the photosensitive substrate (W), characterized in that it has light modulator 123 to create two light beams (L1, L2) with frequencies that are different from one another from a position detection light beam (L), a drive 124 to provide variable frequency ultrasonic waves to this light modulation means, an irradiation optical system 127, 128 to guide the two light beams (L1, L2) created by light modulation means 123 to the projection optical system (PL) and to alignment mark (14X) on mask (R) and to alignment mark (16X) on photosensitive substrate (W), and a detector 103 to photoelectrically detect the interference light (LR, LW) formed by a plurality of combinations of diffracted light generated in the same direction from the two alignment marks (14X, 16X). It adjusts the ultrasonic wave frequency provided by the drive 124 to the light modulator 123 according to the pitch of the alignment mark (14X, 16X) of the two alignment marks that is being detected.

When the pitches of two alignment marks (14X, 16X) are set so that the diffracted light from the respective marks is not superimposed, a position detecting apparatus according to the present invention switches the frequency of the ultrasonic waves supplied to that light modulator 123 in a time-shared manner, and sets the intersection angle of two light beams (L1, L2) with different frequencies emitted from that light modulator 123 according to the pitch of the alignment mark (14X) and the alignment mark (16X) in sequence. By doing so, the positions of the alignment marks (14X, 16X) are detected in sequence via a shared irradiation optical system 127, 128, and the position detecting method of the present invention is implemented.

Next, we shall explain another embodiment of the present invention with reference to drawings. This example shows a state in which part of the reticle pattern is projected onto a wafer via a projection optical system. It is a step and scan type of projection exposure apparatus, which gradually copies the reticle pattern image to each shot region on a wafer by synchronous scanning of reticle and wafer by a projection optical system. The present invention is employed when aligning the reticle and wafer.

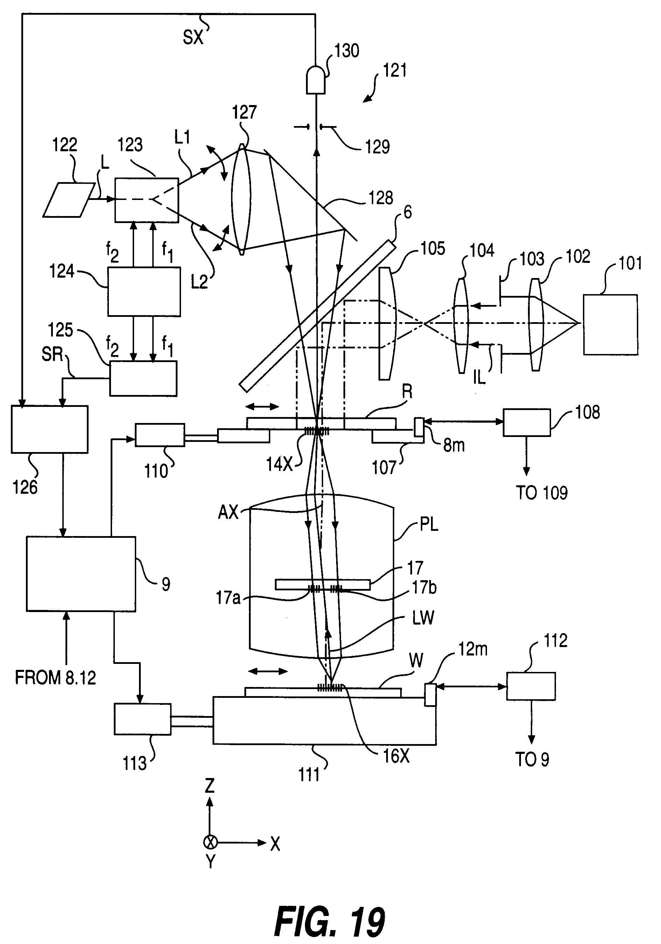

FIG. 19 is a schematic structural drawing showing this example of a projection exposure apparatus. In FIG. 19, illumination light for exposure IL is emitted from an optical system 1, whose luminance distribution has been made homogeneous and which consists of an exposure light source for exposing, fly eye lenses, etc. This light IL passes through a first relay lens 102, a variable field stop 103 (reticle blind), a second relay lens 104, and a condenser lens 105 and impinges upon a dichroic mirror 106. Then illumination light IL is reflected downward by the dichroic mirror 106 and illuminates the slit-shaped illumination region of the pattern region on reticle R with homogeneous luminance distribution. Excimer laser light from a KrF excimer laser (wavelength 248 nm) or an ArF excimer laser (wavelength 193 nm) is used as the illumination light IL in this example. However, it is also possible to use harmonics of metal vapor lasers or YAG lasers or mercury lamp rays (I-lines with a wavelength of 365 nm, and so forth) as the illumination light IL.

When doing an exposure, the illumination light IL that passed through the illumination region on reticle R enters a projection optical system PL that is telecentric at both ends (or at one end at the wafer side), and the pattern in that illumination region is reduced by the projection optical system PL by projection magnification M (M is the projection magnification based on the illumination light for exposure; typical values are 1/4, 1/5, etc.), and this image is projected and exposed on the slit-shaped exposure region on a wafer W, whose surface is coated with photoresist.

In the following explanation, the Z axis is parallel to the projection optical system PL's optical axis AX, the X axis is parallel to the sheet of paper bearing FIG. 19 and lying in the plane perpendicular to the Z axis, and the Y axis is perpendicular to the sheet of paper bearing FIG. 19.

In this example the reticle R is supported by a reticle stage 107, and the reticle stage 107 is structured so that it can position the reticle R two-dimensionally within the plane perpendicular to the projection optical system PL's optical axis AX, and so that it can scan the reticle R in the X direction (scanning direction) at a predetermined velocity. The two-dimensional coordinates of the reticle stage 107 measured using a mobile mirror 8m on the reticle stage 107 and a laser interferometer 108 are supplied to a main controller 109 which controls the overall operation of the entire apparatus, and the main controller 109 controls the position of the reticle stage 107 and the scanning velocity via a reticle stage drive unit 10 based on the supplied coordinates.

The wafer W is carried on and positioned on a wafer stage 111 via a microscopically rotatable wafer holder (not shown in the drawing). The wafer stage 111 is structured so that it can position the wafer W in the X direction and Y direction, and so that it can scan the wafer W in the X direction at a constant velocity. The wafer stage 111 controls the position of the wafer W in the Z direction (focus position) by the autofocus method. The two-dimensional coordinates of the wafer stage 111 measured using a mobile mirror 12m on the water stage 111 and a laser interferometer 112 are supplied to the main controller 109, and the main controller 109 controls the operation of the water stage 111 via a wafer stage drive unit 113. When scanning and exposing, the reticle R is scanned via the reticle stage 107 in the +X direction (or -X direction) at velocity Vr, and at the same time one shot region on the water W is scanned via the wafer stage 111 in the -X direction (or +X direction) at velocity $\beta \cdot Vr$ ($\beta$ is the projection magnification).

This example uses an alignment sensor for the TTR method and for the two-beam interference method (LIA method). Thus, diffraction grating shaped alignment marks (reticle marks and water marks) are formed on the reticle R and on each shot region of water W, respectively.

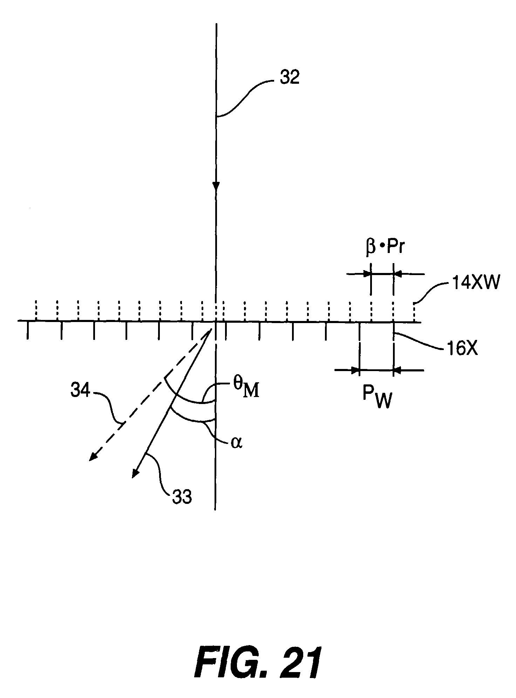

FIG. 20 (A) shows the arrangement of reticle marks on the reticle R. In this FIG. 20 (A) X-axis diffraction grating shaped reticle mark 14X, which consists of light transparent parts and light shielding parts arranged at a predetermined pitch in the X direction, and Y-axis diffraction grating shaped reticle mark 14Y, which consists of light transparent parts and light shielding parts arranged at a predetermined pitch in the Y direction, are formed in the +Y direction on a light shielding belt surrounding the reticle R's pattern region PA. An X-axis diffraction grating shaped reticle mark 15X and a Y-axis diffraction grating shaped reticle mark 15Y are also formed in the -Y direction on the light shielding belt and one symmetrical with the previous pair of reticle marks.

FIG. 20(B) shows the arrangement of wafer marks provided on one shot region SA on the wafer W. In FIG. 20(B) X-axis diffraction grating shaped wafer mark 16X, which includes projecting parts and depressed parts arranged at a predetermined pitch in the X direction, and Y-axis diffraction grating shaped wafer mark 16Y, which consists of projecting parts and depressed parts arranged at a predetermined pitch in the Y direction, are formed so they are adjacent to shot region SA in the -Y direction. An X-axis diffraction grating shaped wafer mark 17X and a Y-axis diffraction grating shaped wafer mark 17Y are also formed adjacent to shot region SA in the +Y direction and symmetrical with the previous pair of wafer marks. When aligning by the TTR method, the positional deviation in the measurement direction between the four reticle marks 14X, 14Y, 15X and 15Y on the reticle R and the corresponding wafer marks 16X, 16Y, 17X and 17Y for shot region SA on the wafer W is detected by the corresponding alignment sensor, and exposure occurs when these detected results fall within the respective predetermined allowed ranges.

Additionally, in this example the alignment light for detecting the position of the reticle mark and the wafer mark is a light beam with a wavelength that does not affect the photoresist on the wafer W, which is to say a light beam whose wavelength differs from that of illumination light for exposure IL. Chromatic aberration (axial chromatic aberration, magnification chromatic aberration) may remain in the alignment light in the projection optical system PL, which performs aberration correction on illumination light for exposure IL. In this example the projection magnification $\beta$ from the reticle R to the wafer W is measured in advance in the projection optical system PL using this alignment light. If the pitch of the reticle mark 14X in the X direction is Pr and the pitch of the wafer mark 16X in the X direction is Pw, pitch Pr and Pw are set so that the following two relationships are established, using optional integers m and n which are equal to or greater than 1.

$$Pw \neq m \cdot \beta \cdot Pr \qquad (14)$$

$$n \cdot Pw \neq \beta \cdot Pr \qquad (15)$$

That is, the pitch $\beta \cdot Pr$ of the image of the reticle mark 14X on the wafer W and the pitch Pw of wafer mark 16X are set so that they are not integral multiples of one another. FIG. 21 shows the relationship between image 14XW of the reticle mark 14X on the wafer W and the wafer mark 16X. In FIG. 21, if pitch $\beta \cdot Pr$ of image 14XW of the reticle mark 14X and pitch Pw of the wafer mark 16X satisfy the relationships of Equation (14) and Equation (15), when a hypothetical light beam 132 impinges perpendicularly upon these two marks the diffraction angle $\theta m$ of m-order (m is an integer equal to or greater than 1) diffracted light 134 from image 14XW does not equal the diffraction angle $\alpha$ of 1-order diffracted light 133 from the wafer mark 16X. That is, m-order diffracted light 134 and 1-order diffracted light 133 are not superimposed, so as described later it is possible to detect only the ±1-order diffracted light from the wafer mark 16X, without being affected by the reticle mark 14X.

Similarly, it is possible to detect only the ±1-order diffracted light from the reticle mark 14X, without being affected by the wafer mark 16X. The same sort of pitch relationship is set for the other reticle marks and wafer marks, and the detection principle is the same.

The structure of one alignment sensor for detecting positional deviation of X-axis reticle mark 14X and wafer mark 16X in the X direction shall be explained.

Returning to FIG. 19, a chromatic aberration control plate 117 to control chromatic aberration of the alignment light in the projection optical system PL is provided near the optical Fourier transform plane (pupil surface) of the reticle R's pattern plane in this example's projection optical system PL, which uses alignment light. The chromatic aberration control plate 117 is formed as a plurality of chromatic aberration control elements (shown as 117a and 117b in FIG. 19) including phase-type diffraction gratings on a glass substrate. These chromatic aberration control elements control chromatic aberration in the alignment light, so the reticle mark 14X and the wafer mark 16X become conjugate relative to the projection optical system PL using alignment light.

An alignment optical system for an X-axis two-beam interference alignment sensor 121 is arranged above the dichroic mirror 6 above the reticle R. In this alignment optical system a laser beam L can be the alignment light (position detection light) emitted from a laser light source 122 such as a He-Ne laser light source, for example. This laser beam L enters a variable frequency two-beam generator system 123. This variable frequency two-beam generator system 123 is structured so that it includes two acousto-optical devices, and an external AOM drive system 24 provides these two acousto-optical devices with high frequency signals whose variable frequencies f1 and f2 have a predetermined frequency difference $\Delta f$; this makes it possible to create two coherent light beams (heterodyne beams) L1 and L2, which have a predetermined frequency difference $\Delta f$ and which have variable exit angles.

Returning to FIG. 19, the pair of coherent light beams L1 and L2 emitted from the variable frequency two-beam generator system 123 with a predetermined frequency difference $\Delta f$ are focused by an objective lens 127 and reach a beam splitter 128, and the light beams L1 and L2 reflected by the beam splitter 128 pass through the dichroic mirror 106 and impinge in such a way that they intersect at the X-axis reticle mark 14X in the pattern plane of the reticle R. When this happens, if the intersection angle of the light beams L1 and L2 conforms to pitch Pr of the reticle mark 14X, interference light is created, which consists of ±1-order diffracted light traveling perpendicularly upward from the reticle mark 14X, and this interference light passes through the dichroic mirror 106 and the beam splitter 128 and enters a photoelectric detector 130, which is a photodiode, etc. Also, a spatial filter 129 is arranged between the beam splitter 128 and the photoelectric detector 130; it is structured so that it allows passage only of the light beam created perpendicularly upward from the reticle mark 14X and the wafer mark 16X, and it blocks light beams other than interference light from the detection target.

Meanwhile, part of the light beams L1 and L2 (these too are referred to as light beams L1 and L2) which impinged on the reticle mark 14X passes through the reticle mark 14X and enters the projection optical system PL. Then the light beams L1 and L2 have their respective light paths polarized by the chromatic aberration control elements 117a and 117b on the chromatic aberration control plate 117 positioned inside the projection optical system PL and are emitted from the projection optical system PL, after which they impinge and intersect at the X-axis wafer mark 16X on the wafer W.

As was the case with the reticle mark 14X, if the intersection angle of the light beams L1 and L2 conforms to pitch Pw of the wafer mark 16X, interference light LW is created which consists of ±1-order diffracted light traveling perpendicularly upward from the wafer mark 16X, and this interference light LW passes through the corresponding chromatic aberration control elements on the chromatic aberration control plate 117 in the projection optical system PL and returns to the reticle mark 14X. The interference light LW, which passes through the reticle mark 14X, passes through the dichroic mirror 106, the beam splitter 128, and the spatial filter 129 and enters the photoelectric detector 130. The frequency Δf optical beat signal SX, which is obtained by photoelectric conversion of the interference light entering the photoelectric detector 130, is supplied to a signal processing system 126.

Furthermore, as shown in FIG. 12, separation S between the AOMs 17A and 17B in the variable frequency two-beam generator system 123 of this example is not 0, so a component modulated to approximately frequency f1 and f2 is superimposed on the emitted light beams L1 and L2, and a high frequency component may also be superimposed an the obtained optical beat signal SX. Therefore a low-pass filter circuit should be added between the photoelectric detector 130 and the signal processing system 126 to remove high frequency components whose frequency is approximately f1/2 from the optical beat signal SX.

High frequency signals with frequencies f1 and f2 separated from the high frequency signals supplied to the variable frequency two-beam generator system 123 are supplied to a mixer circuit 125 from the AOM drive system 124, and these high frequency signals are mixed by the mixer circuit 125 to generate the reference beat signal SR with frequency Δf (=f1-f2) . This reference beat signal SR is supplied to the signal processing system 126. The signal processing system 126 compares the phases of the reference beat signal SR and the optical beat signal SX and finds phase difference φ between optical beat signal SX and reference beat signal SR.

A pulse signal from a simple standard clock generator device can be used instead of the reference beat signal SR. In FIG. 19 the alignment sensor 121 is constructed of the elements from the laser light source 122 through the photoelectric detector 130. The alignment optical system is constructed of the laser light source 122, the variable frequency two-beam generator system 123, and the objective lens 127 through the photoelectric detector 130.

Next, using the alignment sensor 121 operation when detecting the positional deviation of the reticle mark 14X on the reticle R and the wafer mark 16X on the wafer W in the X direction shall be explained.

First, in order to detect the position of the wafer mark 16X, the frequencies f1 and f2 of the high frequency signals supplied to the variable frequency two-beam generator system 123 are adjusted so that the incidence angle θw at the wafer mark 16X formed by light beams L1 and L2 emitted from the variable frequency two-beam generator system 23 satisfies the following equation. However, λ is the wavelength of the light beams L1 and L2 (central wavelength) and Pw is the pitch of the wafer mark 16X, and satisfying Equation (16) means that the intersection angle of the light beams L1 and L2 conforms to pitch Pw of the wafer mark 16X.

$$\sin \theta w = \lambda / Pw \qquad (16)$$

FIG. 18(A) shows a state in which the intersection angle of the light beams L1 and L2 conforms to pitch Pw of the wafer mark 16X in this manner. In FIG. 18(A), when two light beams L1 and L2 impinge on the reticle mark 14X, part of them becomes 0-order light L10 and L20, which passes through to the projection optical system PL side. When this happens, diffraction also occurs at the reticle mark 14X; for example, with regard to the light beam L1, 1-order diffracted light L11 and 2-order diffracted light L12 and so forth are created at the reticle mark 14X. However, in this example Equation (14) and Equation (15) are operating, so this diffracted light of 1-order and higher has no negative effects.

Suppose the inequality of Equation (14) and Equation (15) is not established, i.e. Equation (14) and Equation (15) operate as equalities. Then 1-order diffracted light L11 and 2-order diffracted light L12 and so forth advance in the same direction as 0-order diffracted light L20, and 1-order and higher diffracted light from the reticle mark 14X mixes with interference light LW from the wafer mark 16X, and the SN ratio of the detected optical beat signal SX degrades. In other words, as long as Equation (14) and Equation (15) are established, 0-order light (light which is not diffracted) L10 and L20 from the light beams L1 and L2 impinging on the reticle mark 14X do not contain superfluous diffracted light, which is to say they are light beams that do not contain reticle R position information,

When 0-order light L10 and L20 impinges on the wafer mark 16X, ±1-order diffracted light is generated from the wafer mark 16X parallel to the interference light LW because of the Equation (16) relationship, and this interference light LW is received by the photoelectric detector 130 (FIG. 19). Meanwhile, reflected diffracted light LR11, LR 21, etc. from the reticle mark 14X cannot exist in combinations going in the same direction because of the Equation (14) and Equation (15) relationship. Therefore the position of the wafer W is detected accurately based on the interference light LW from the wafer mark 16X.

Next, when detecting the position of the reticle mark 14X, the frequencies f1 and f2 of the high frequency signals supplied to the variable frequency two-beam generator system 123 are adjusted so that the incidence angle θr at the reticle mark 14X formed by light beams L1 and L2 emitted from the variable frequency two-beam generator system 123 satisfies the following equation. However, Pr is the pitch of the reticle mark 14X, and satisfying Equation (17) means that the intersection angle of the light beams L1 and L2 conforms to pitch Pr of the reticle mark 14X.

$$\sin \theta r = \lambda/Pr \qquad (17)$$

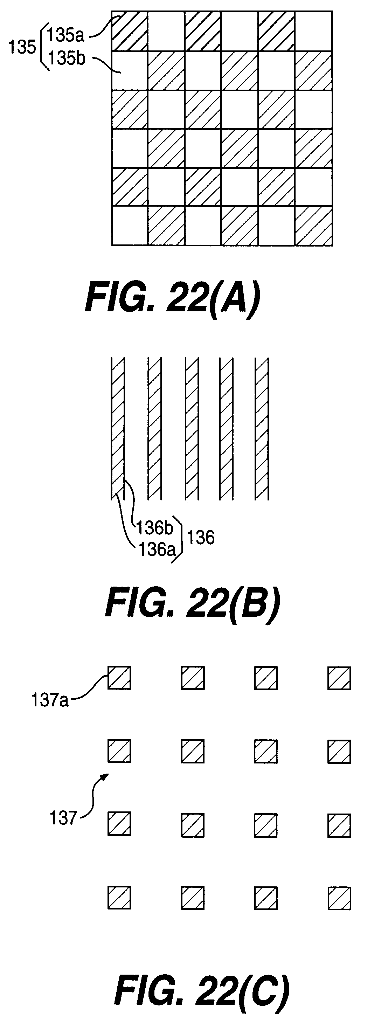

FIG. 22B shows a state in which the intersection angle of the light beams L1 and L2 conforms to pitch Pr of the reticle mark 14X in this manner. In FIG. 18(B), when two light beams L1 and L2 impinge on the reticle mark 14X, interference light LR consisting of ±1-order diffracted light from the reticle mark 14X is created in the direction nearly perpendicular to the reticle mark 14X and is received by the photoelectric detector 130 of FIG. 19. When this happens 1-order diffracted light LW11 and LW21 are generated from the wafer mark 16X by 0-order light L10 and L20 from the reticle mark 14X, but Equation (14) and Equation (15) apply so these 1-order diffracted light beams LW11 and LW21 are not parallel to the interference light LR. Therefore, only interference light LR is detected with a high SN ratio, and the position of the reticle mark 14X is detected with high precision.

After completing relative positional detection of the reticle R and the wafer W in the X, Y, and Z directions using the aforesaid reticle mark and wafer mark, the main controller 109 adjusts the positions of the reticle stage 107 and the wafer stage 111 and alignment is completed. Then, after alignment is completed, the main controller 109 outputs a signal that opens a shutter (not shown in the drawing and provided inside the illumination system), opens the shutter, and the reticle R and the wafer W are relatively scanned. The apparatus shifts to the exposure operation for copying the pattern on the reticle R onto the wafer W.

One example of specific pitch Pr for the reticle mark 14X and pitch Pw for the wafer mark 16X to satisfy the relationships of Equation (13) and Equation (14) is as follows.

$$Pw = 0.93\beta \cdot Pr \qquad (18)$$

That is, pitch Pw for the wafer mark 16X is set to 93% of Pr for the reticle mark 14X, corrected for exposure magnification β based on alignment light. Doing so almost eliminates the difference in the opening angles of the two light beams L1 and L2 in the case of FIG. 22A and the case of FIG. 22B, and the light paths of the two light beams L1 and L2 can be regarded as nearly identical when detecting the position of the reticle mark 14X and the water mark 16X, and the effect of air fluctuations on the light path above the reticle R can be absolutely minimized.

In this example, as described above, the position of the wafer mark 16X and the reticle mark 14X are sequentially detected in a time-shared way by switching high frequency signal frequencies f1 and f2 supplied to the variable frequency two-beam generator system 23 in FIG. 19. When doing so, the speed of position detection by the heterodyne interference method is very high, and detection can be done at a cycle sufficiently faster than air fluctuations or the mechanical vibration cycle (about 100 Hz). The time needed for position detection is very short.

The present invention further contemplates a method of finding the positional deviation of the reticle mark 14X and the wafer mark 16X based on the reference beat signal SR and the optical beat signal SX output from the photoelectric detector 130. As described earlier, the signal processing system 126 finds phase difference θ between the optical beat signal SX and the reference beat signal SR. When doing so, if the phase difference θ of the optical beat signal SX detected when detecting the position of the reticle mark 14X is θr, the positional deviation ΔXr in the X direction from the reference position of the reticle mark 14X (reticle R) on the reticle stage is as follows.

$$\Delta Xr = \theta r \cdot Pr/(2\pi) \qquad (19)$$

Similarly, if the phase difference θ of the optical beat signal SX when detecting the position of the wafer mark 16X is θw, the positional deviation ΔXw in the X direction from the reference position of the wafer mark 16X (wafer W) on the wafer stage is as follows.

$$\Delta Xw = \theta w \cdot Pw/(2\pi) \qquad (20)$$

Using Equation (19) and Equation (20), the signal processing system 126 calculates the relative positional deviation in the X direction between the reticle R and the wafer W. That is to say, if it uses the projection magnification M based on illumination light for exposure and the projection magnification β based on alignment light, Equation (20) gives the positional deviation based on alignment light, so first of all Equation (20) is converted to positional deviation ΔXw' based on illumination light for exposure.

$$\Delta Xw' = M \cdot \Delta Xw/\beta \qquad (21)$$

Next, positional deviation ΔX in the X direction on the wafer stage between the reticle mark 14X and the wafer mark 16X based on illumination light for exposure is obtained by the following equation.

$$\Delta X = -M \cdot \Delta Xr - \Delta Xw' \qquad (22)$$

However, Equation (22) is one in which a reversed image is copied by the projection optical system PL. This positional deviation $\Delta X$ is supplied to the main controller 109. Positional deviations for other marks are also supplied to the main controller 109, and based on these positional deviations the main controller 109 corrects the positional deviation of the reticle R and the wafer W via the reticle stage drive system 110 and the wafer stage drive system 113.

In the embodiment described above the best frequency of the optical beat signal SX is identical when detecting the reticle mark 14X and the wafer mark 16X, so signal processing is simplified. Nevertheless, the best frequency of the optical beat signal SX does not always have to be identical when detecting these two marks. That is to say, the beat frequency is not included in Equation (19) and Equation (20), so the detected positional deviation is the same even if the beat frequency is changed.

Also, in the embodiment described above the reticle mark is separated into a part for the X axis and a part for the Y axis, as shown in FIGs. 20(A) and 20(B). Nevertheless, this reticle mark can also be a two-dimensional mark with the X axis part and the Y axis part intermixed.

FIG. 22(A) shows a reticle mark 35 consisting of two-dimensional marks. In FIG. 22(A) the reticle mark 135 is structured so that square light-shielding parts 135a and square light-transparent parts 135b are arranged in a grating shape. In this case the width ratio between square light-shielding parts 135a end square light-transparent parts 135b is 1:1. In this case the corresponding wafer mark is also structured of two-dimensional marks in the same way.

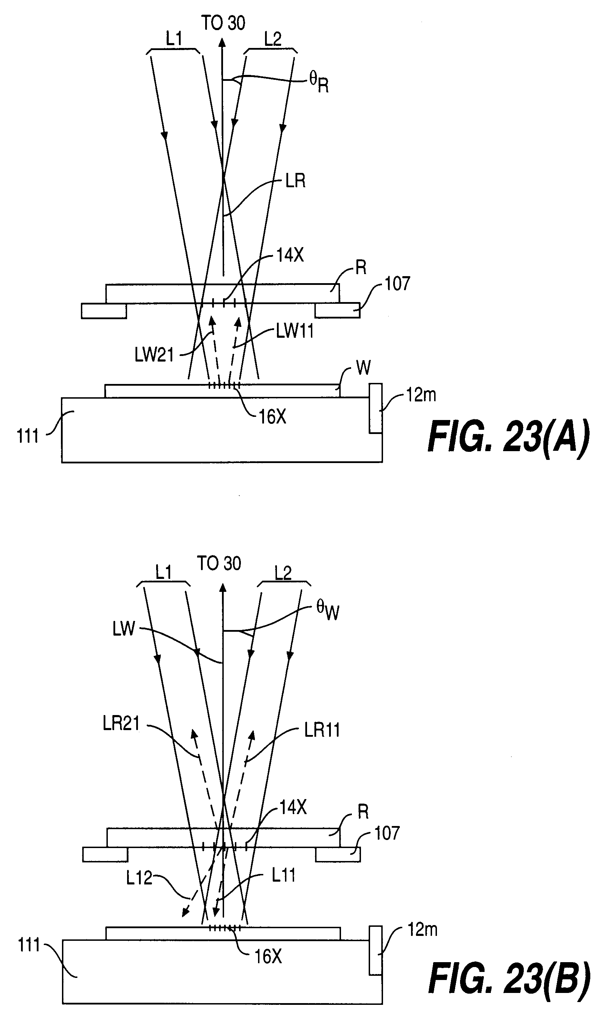

The aforesaid embodiment described an example of detecting the position of the alignment mark 14X on the reticle R and the alignment mark 16X on the wafer W in a projection exposure apparatus that copies the pattern on the reticle R onto the wafer W via the projection optical system PL but as shown in FIGs. 23(A) and 23(B) the present invention can also be used in the proximity type of exposure apparatus which brings the pattern on the reticle (R) near to or in intimate contact with the wafer (W) and exposes it without using the projection optical system (PL).

FIGs. 23(A) and 23(B) shows an enlarged view of the exposure part that exposes the pattern on the reticle R onto the wafer W in a proximity type of exposure apparatus. In the exposure apparatus shown in FIGS. 23(A) and 23(B), differences from the example shown in FIG. 19 are that there is no projection optical system PL to project the pattern on the reticle R onto the wafer W, and the reticle stage 107, and the wafer stage 111 does not move when making exposures. These elements are controlled by the main controller 109 so that they move only when positioning the reticle and wafer. In other respects, the exposure apparatus of FIGS. 23(A) and 23(B) is the same as that shown in FIG. 19.

There is no projection optical system PL in the proximity type of exposure apparatus shown in FIGs. 23(A) and 23(B), but the reticle R and the wafer W are arranged close to one another, so Equations (11) through (14), Equation (17), Equation (21), and Equation (22) can be used by making the projection magnification of the projection optical system PL $\beta$ equal to 1, and in this case the aforesaid Equations (11)~(22) relationships apply.

The alignment sensor 121 of FIG. 19 can be used as-is as the alignment sensor in the FIGs. 23(A) and 23(B) example. The positional deviation of the reticle mark 14X on the reticle R and the wafer mark 16X on the wafer W can be detected in the same was as the FIG. 19 example by using this sensor. Specifically, first, in order to detect the wafer mark 16X, the high frequency signals f1 and f2 supplied to the variable frequency two-beam generator system 123 in FIG. 19 are adjusted and set so that the incidence angle $\theta$w at the wafer mark 16X formed by light beams L1 and L2 emitted from the variable frequency two-beam generator system 123 satisfies the aforesaid Equation (15). When this happens, as shown in FIG. 23(B), the two light beams L1 and L2 irradiate each mark, and interference light LW is generated perpendicularly from the wafer mark 16X for detection. Nevertheless, the relationships of the aforesaid Equation (13) and Equation (14) apply in this example too. Considering, for example, the light beam L1, the unnecessary diffracted light L11 and L12 transmitted and diffracted by the reticle mark 14X and the unnecessary diffracted light LR11 and LR21 reflected and diffracted by the reticle mark 14X are created in directions that are different from the interference light LW used for detection, so only the interference light LW for detection reaches the photoelectric detector 130 inside the alignment sensor 121 which serves as the alignment system, so the position of the wafer W is detected with high precision.

Next, in order to detect the reticle mark 14X, the high frequency signals f1 and f2 supplied to the variable frequency two-beam generator system 123 shown in FIG. 19 are adjusted and set so that the incidence angle $\theta$r at the reticle mark 14X formed by light beams L1 and L2 emitted from the variable frequency two-beam generator system 123 satisfies the aforesaid Equation (16). When this happens, as shown in FIG. 23(A), the two light beams L1 and L2 irradiate each mark, and interference light LW is generated perpendicularly from the reticle mark 14X for detection. Nevertheless, the relationships of the aforesaid Equation (13) and Equation (14) apply in this example too, so the unnecessary 1-order diffracted light LW11 and LW21 reflected and diffracted by the wafer mark 16X are created in directions that are different from the interference light LW used for detection, so only the interference light LR for detection reaches the photoelectric detector 130 inside the alignment sensor 121, so the position of the reticle R is detected with high precision.

After completing relative positional detection of the reticle R and the wafer W in the X, Y, and $\theta$ directions

using the aforesaid reticle mark and wafer mark, the main controller adjusts the positions of the reticle stage 107 and the wafer stage 111 and alignment is completed. Then, after alignment is completed, the main controller 109 outputs a signal that opens a shutter not shown in the drawing and provided inside the illumination system, and opens the shutter, and shifts to the exposure operation for copying the pattern on the reticle R onto the wafer W.

However, in this example the light beam that transparently penetrates the reticle mark is used to detect the position of the wafer mark, so the width of the light transparent parts relative to the width of the light shielding parts should be wide so that ample position detection light reaches the wafer mark. FIG. 22(C) shows a reticle mark 127 in which the width of the light transparent parts is wider than the width of the light shielding parts 137a. Also, a one-dimensional grating-shaped reticle mark 136, with the width of the light transparent parts 136b being greater than the width of the light shielding parts 136a as shown in FIG. 22(B), should be used instead of the reticle mark 14X shown in FIG. 20(A).

According to the alignment apparatus of the present invention, ultrasonic waves of variable frequencies are applied by a drive means to the acousto-optical modulators in a two-luminous-beam generation means. Due to this fact, the positions of diffraction grating marks can be detected with a high degree of precision by simply adjusting the frequency of the ultrasonic waves without requiring undue complexity in the optical system, by precisely matching the two light beams that are generated from the two-luminous-beam generators with the diffraction grating marks to be detected.

In cases in which the drive varies the frequency of the ultrasonic waves that are to be applied to the acousto-optical modulator according to the pitch of the diffraction grating mark, diffraction grating marks having multiple and different pitches can be accommodated by simply changing the frequencies of the ultrasonic waves that are applied to the acousto-optical modulator. Because change in the frequency of ultrasonic waves can be performed in an extremely short time, even when the positions of diffraction grating marks of a novel pitch must be determined, the task can be accomplished rapidly and virtually in realtime.

In cases where at least one of the acousto-optical modulators comprises a medium that produces an anisotropic Bragg diffraction, the diffraction efficiency of anisotropic Bragg diffraction can theoretically be increased to approximately 100%. In this way, the overall diffraction can be substantially increased. The use of anisotropic Bragg diffraction permits an increase in the range of variation in the diffraction angle for diffracted beams that are generated by acousto-optical modulators (the range of variation in the frequency of the ultrasonic wave to be applied can be broadened). As a result, the present invention offers the advantage of permitting the detection of diffraction grating mark positions with a broad range of pitches.

Further, the use of anisotropic Bragg diffraction moderates the sound speed of the ultrasonic waves within a given medium, when compared with isotropic Bragg diffraction. This results in an order-of-magnitude reduction in the electric power to be applied. The low speed of sound reduces the relative wavelength of ultrasonic waves, thus reducing the pitch of the interference fringes that are produced by causing two light beams to interfere with each other. In this manner, the cross-sectional areas of the light beams that are made incident upon a given medium can be reduced. Small luminous beam cross-sections permit a reduction in the size of the ultrasonic wave-acting region, and, consequently, lead to a reduction in the ultrasonic wave power that is applied. The sum of these effects is that the power to be applied to acousto-optical modulators can be reduced by a factor or 10 or even by 100 when compared with the situation in which isotropic Bragg diffraction is employed.

In cases in which at least one of the acousto-optical modulators comprises a medium that produces Raman-Nath diffractions, by symmetrically applying ultrasonic waves of different frequencies to the one acousto-optical modulator that produces Raman-Nath diffractions, it is possible to generate two light beams of different frequencies from each other while keeping a simple structure.

In cases in which the drive applies ultrasonic waves of variable frequencies but a constant frequency difference to two locations on the acousto-optical modulator, even when the frequencies of the ultrasonic waves are changed in order to treat diffraction grating marks of different pitches, the beat frequency of the interference beams that are produced by the diffraction grating marks remains constant. This offers the advantage of making the signal processing system simpler.

The exposure apparatus equipped with the alignment apparatus of the present invention, by means of the alignment apparatus, can detect the positions of diffraction grating marks of various pitches located on a given photosensitive substrate. Therefore, the exposure apparatus offers the advantage of achieving a high degree of superimposing precision when dealing with various photosensitive substrates.

The configuration of the present alignment apparatus is simple and is driven by low power, and can generate light beams frequency modulated at a high diffraction efficiency. This is possble because it has multiple acousto-optical modulators that polarize light beams in two different directions with anisotropic diffraction efficiencies. In this way, the heat generation in the apparatus can be minimized and the apparatus can be made smaller but can be capable of providing alignment which meets stringent specifications.

The diffraction efficiencies can be increased even more when the acousto-optical modulators in a beam producing element are made up with two acousto-optical modulators that have anisotropic diffraction efficiencies and are supplied with ultrasonic waves of different frequencies, and at the same time, when diffracted light beams in these two acousto-optical modulaters are directed in different directions and guided to the objective lens system as two light beams of different frequencies. In addition, if different driving frequencies are allocated to the two acousto-optical modulators, the two beams can have a difference in frequencies which can be electrically processed easily.

When a relay optical system is installed between the two acousto-optical modulators such that ultrasonic waves of different frequencies are introduced in opposite directions to the two acousto-optical modulators, which are conjugate to each other, the angle of the two diffracted light beams from the acousto-optical modulators corresponds to their wavelength and they are symmetric to the optical axis. If the two diffracted light beams interfere with each other, the pitch along which the interferance fringes flow becomes constant regardless of the wavelength. This configuration makes highly accurate alignment possible even if the alignment beams are white light or multiwave light. By using wideband beams, the interference from the thin resist layer or confusion from different step heights that exist in diffraction graing marks can be reduced.

By installing the two acousto-optical modulators close to each other and by having their ultrasonic waves of different frequencies applied to them in a reversed direction, the simple configuration provides angles of diffraction which correspond to the polarized direction of the two diffracted beams of the acouto-optical modulators. In addition, the two diffracted light beams are generated approximatele symmetric to the optical axis to provide highly accurate alignment detection even if the alignment light beams are white light or multiwavelength light.

The front end acousto-optical modulater produces the zeroth order and the 1st order diffracted light beams at a substantially even propotion. When the back end acouto-optical modulator is configured such that it maximizes the diffraction efficiency of the 1st order diffracted light beams with respect to the zeroth order diffracted light beams emitted from the front end acousto-optical modulator, the overall diffraction efficiency of the two light beams can be equal and large.

If at least one of the acousto-optical modulaters in the two beam producing means is made of a medium that generates anisotropic Brag diffraction, the theoretical diffraction efficiency generated by the anisotropic Bragg diffraction method is 100%, to maximize the overall diffraction efficiency.

In addition, in anisotropic Bragg diffracton, the speed of ultrasonic waves in the medium is slower than that in isotrobic Bragg diffraction. This reduces the power applied to the medium. Furthermore, because the speed is so slow, which makes the relative ultrasonic wavelength so small that the cross sectional area of the region in which light beams are introduced to the medium becomes relatively small. If the cross section of the region in whicih light beams are introduced is small, the ultrasonic operating region can be made smaller. As a result, the ultrasonic wave power applied to the modulator can be reduced. Taking all these factors into account, the power applied to the acousto-optical modulator can be as small as 1/10 to 1/100 when using the anisotropic Bragg diffraction method.

Next, in the exposure apparatus of the present invention the effect of the alignment detection apparatus of the present invention, provides highly accurate alignment for the diffraction grating marks on a photosensitive substrate by using light beams that are frequency modulated with a low driving power at a high dffraction efficiency. As a result, the heat generated in the apparatus can be minimized to obtain highly accurate alignment capability.

The position detecting method of the present invention determines the pitch of an alignment mark on a mask (reticle mark) and the pitch of an alignment mark on a photosensitive substrate (wafer mark) so that diffracted light from these two marks is not superimposed, so it has the advantage that it is possible to use light beams advancing along nearly identical (coaxial) light paths when detecting positional deviation between these two marks via a projection optical system that uses position detection light or alignment light with a different frequency than illumination light for exposure. Therefore, the positional deviation of the two marks can be detected via a shared simple optical system, and the effect of fluctuations caused by gas above the mask can be absolutely minimized, and positional deviation can be accurately detected.

When a projection optical system is used and the mark pitch is Pr and the pitch of the alignment mark on the photosensitive substrate is Pw and the projection magnification from mask to photosensitive substrate in the projection optical system based on position detection light is $\beta$, it becomes simple to keep diffracted light from the two marks from being superimposed by setting Pr and Pw to establish the relationships of Equation (11) and Equation (12) and by using optional integers m and n which are equal to or greater than 1.

The present invention can also be used in a proximity type of exposure apparatus that does not use a projection optical system, so of course the aforesaid benefits can also be obtained in a proximity type of exposure apparatus.

It also has the benefit that the positional deviation of two marks can be detected with one light receiving unit if the phase of diffracted light from the alignment mark on the mask using position detection light and the phase of diffracted light from the alignment mark on the photosensitive substrate are detected by time sharing.

By comparing the phases of diffracted light from these two alignment marks using this position detection light and the phases of respective predetermined reference signals it is possible to independently detect positional deviation from the reference positions of these two marks when finding positional deviation for these two alignment marks. Therefore it has the benefit of being able to accurately detect positional deviation based on illumination light for exposure by first finding in advance the projection magnification based on illumination light for exposure in the projection optical system and projection magnification based on position detection light or alignment light, and then converting the positional deviation of the photosensitive substrate's alignment mark into positional deviation based on illumination light for exposure.

**Claims**

1. An alignment apparatus for an exposure apparatus that transfers the image of a reticle onto a developing surface through the use of a first light beam having a first frequency, a second light beam having a second frequency different from the first frequency, an objective optical system to condense the first light beam and the second light beam and to direct the condensed light beams onto a first diffraction grating mark on the reticle and onto a second diffraction grating mark on the developing surface at two predetermined angles, and a detector that photoelectrically detects interference light formed by beams that are diffracted from the diffraction grating mark, such that the alignment apparatus detects the position of the diffraction grating marks based upon the output signals from the detector, the alignment apparatus comprising:

    a light source to project light beams along an optical path;
    an acousto-optic modulator disposed on the optical path of the light beams emanating from the light source, and
    a modulator driver to apply ultrasonic waves having variable frequencies to the acousto-optic modulator to cause the acousto-optic modulator to produce two light beams having different frequencies from each other from the light beams emanating from the light source.

2. An alignment apparatus according to claim 1, wherein the modulator driver varies the frequency of the ultrasonic waves that are applied to the acousto-optic modulators according to the pitch of the diffraction grating marks.

3. An alignment apparatus according to claim 2, wherein the light source produces monochromatic light beams.

4. An alignment apparatus according to claim 2, wherein the light source produces light beams with multiple frequencies.

5. An alignment apparatus according to claim 2, wherein the acousto-optic modulator comprises a medium that produces anisotropic Bragg diffraction.

6. An alignment apparatus according to claim 2, wherein the acousto-optic modulator comprises a medium that produces a Raman-Nath diffraction.

7. An alignment apparatus according to claim 2, wherein the modulator driver applies ultrasonic waves of variable frequencies separated by a constant frequency difference to two locations on the acousto-optic modulator.

8. An alignment apparatus according to claim 2, wherein the surface comprises a photosensitive substrate having a plurality of shot regions.

9. An exposure apparatus having an alignment apparatus according to claim 8, comprising a plurality of diffraction grating marks singly disposed in each of the shot regions to enable alignment of the reticle to each of the shot regions for the transcription of mask patterns to each of the shot regions.

10. An exposure apparatus according to claim 9, further including an alignment stage for effecting relative movement between the reticle and the photosensitive substrate in response to the detection of the diffraction grating marks in the shot areas of the photosensitive substrate to align the reticle and the shot areas.

11. An alignment apparatus for aligning a reticle with shot areas of a photosensitive surface by detecting the positions of diffraction grating marks, comprising:

    a light source for projecting two light beams of different frequencies along an optical path;
    an objective optical system on the optical path to converge the two light beams and to direct the converged light beams to diffraction grating marks on the reticle and the photosensitive surface;
    a photoelectric detector for detecting interference among light beams diffracted by the diffraction grating marks; and
    an acousto-optical modulator for splitting light beams from the light source into two light beams of different frequencies by an anisotropic diffraction method and for directing the two light beams in different directions.

12. An alignment apparatus according to claim 11, wherein the light source projects monochromatic light or multiple frequencies.

13. An alignment apparatus according to claim 11, wherein the acousto-optical modulator comprises two acousto-optical modulators, each of which has anisotropy in diffraction efficiency.

14. An alignment apparatus according to claim 13, further including a modulator driver for driving the acousto-optical modulators by ultrasonic waves of different frequencies to cause diffracted light beams to progress in different directions in the acousto-optical modulators.

15. An alignment apparatus according to claim 14, further including a relay optical system between the two acousto-optical modulators to cause the ultrasonic operating regions of the two acousto-optical modulators to be conjugate, and wherein the ultrasonic waves of the different frequencies are applied to the two acousto-optical modulators in the conjugate state in inverse directions to each other.

16. An alignment apparatus according to claim 14, wherein the two acousto-optical modulators are positioned adjacent to each other and are driven by different ultrasonic frequencies in mutually inverse directions.

17. An alignment apparatus according to claim 14, wherein the first acousto-optical modulator produces zeroth and 1st diffracted light beams at a substantially equal ratio with respect to incoming light beams and the second acousto-optical modulator is configured such that the diffraction efficiency thereof is maximized for the 1st order diffracted light beams with respect to the zeroth order beams from the first acousto-optical modulator.

18. An alignment apparatus according to claim 14, wherein at least one of the acousto-optical modulators is made of a medium that causes anisotropic Bragg diffraction.

19. An exposure apparatus having an alignment apparatus according to claim 14, comprising an alignment stage for providing relative movement between the reticle and the photosensitive substrate to align the reticle and selected areas of the photosensitive substrate to enable the transfer of mask patterns on the reticle to the selected areas of the photosensitive substrate by detecting the diffraction grating marks formed on the photosensitive substrate.

20. A position detecting method to detect positional deviation between a grating-shaped alignment mark on a mask and a grating-shaped alignment mark on a photosensitive substrate, comprising the steps of:

setting the pitch of the alignment mark on the mask and the pitch of the alignment mark on the photosensitive substrate so that diffracted light from the two alignment marks when illuminated with position detection light is not superimposed; and
detecting the positional deviation of the two alignment marks based on the phase of light diffracted from the two alignment marks obtained when the two alignment marks are simultaneously illuminated with the position detection light.

21. The position detecting method according to claim 20, wherein when the mask pattern is copied to the photosensitive substrate via a projection optical system, if the pitch of the alignment mark on the mask is Pr and the pitch of the alignment mark on the photosensitive substrate is Pw and projection magnification of the projection optical system from the mask to the photosensitive substrate based on the position detection light is $\beta$, pitch Pr and Pw are set so that the following two relationship, are established, using optional integers m and n which are equal to or greater than 1:

$$Pw \neq m \cdot \beta \cdot Pr \text{ and } n \cdot Pw \neq \beta \cdot Pr$$

22. The position detecting method according to claim 20, wherein if the pitch of the alignment mark on the mask is Pr and the pitch of the alignment mark on the photosensitive substrate is Pw, pitch Pr and Pw are set so that the following two relationships are established, using optional integers m and n which are equal to or greater than 1:

$$Pw \neq m \cdot Pr \text{ and } n \cdot Pw \neq Pr$$

23. The position detecting method cited in claim 20, further including the steps of detecting in a time shared manner the phase of diffracted light from the alignment mark on the mask and the phase of diffracted light from the alignment mark on the photosensitive substrate.

24. The position detecting method cited in claim 20, further including the step of detecting the positional deviation of the two alignment marks by comparing the phases of diffracted light from the two alignment marks with the respective predetermined reference signal phases using the position detection light.

**25.** A position detecting apparatus which for use with an apparatus for copying a pattern formed on a mask onto a photosensitive substrate with illuminating light for exposure, the position detecting apparatus using position detection light of a predetermined wavelength to detect positional deviation between a grating-shaped alignment mark on the mask and a grating-shaped alignment mark on the photosensitive substrate, comprising:

a light modulator to project two light beams with different frequencies;
a drive to provide variable frequency ultrasonic waves to the light modulation means;
an irradiation optical system to guide the two light beams from the light modulator to the projection optical system and to the alignment mark on the mask and to the alignment mark on the photosensitive substrate; and
a detector to photoelectrically detect interference light formed by a plurality of combinations of diffracted light generated in the same direction from each of alignment marks and to adjust the ultrasonic wave frequency provided by the drive to the light modulator means according to the pitch of the alignment mark of the two alignment marks being detected.

**26.** An alignment apparatus according to claim 3, wherein the acousto-optic modulator comprises a medium that produces anisotropic Bragg diffraction.

**27.** An alignment apparatus according to claim 3, wherein the acousto-optic modulator comprises a medium that produces a Raman-Nath diffraction.

**28.** An alignment apparatus according to claim 4, wherein the acousto-optic modulator comprises a medium that produces anisotropic Bragg diffraction.

**29.** An alignment apparatus according to claim 4, wherein the acousto-optic modulator comprises a medium that produces a Raman-Nath diffraction.

**FIG. 1(A)**

**FIG. 1(B)**

FIG. 2(A)

FIG. 2(B)

FIG. 3(A)

FIG. 3(B)

FIG. 4

FIG. 5

FIG. 6

FIG. 7

FIG. 8

FIG. 9

FIG. 10(A)

FIG. 10(B)

**FIG. 11**

**FIG. 12**

**FIG. 13**

**FIG. 14**

**FIG. 15**

**FIG. 17**

**FIG. 16**

# FIG. 18(A)

# FIG. 18(B)

# FIG. 20(A)

# FIG. 20(B)

**FIG. 19**

**FIG. 21**

**FIG. 22(A)**

**FIG. 22(B)**

**FIG. 22(C)**

FIG. 23(A)

FIG. 23(B)